# EUROPÄISCHE PATENTSCHRIFT

(11) **EP 3 262 664 B1**
(45) Veröffentlichungstag und Bekanntmachung des Hinweises auf die Patenterteilung: **09.01.2019**
(21) Anmeldenummer: 16704640.8
(22) Anmeldetag: 16.02.2016
(51) Int. Cl.: H01F 29/04

(54) **VERFAHREN ZUM ÄNDERN DER AKTIVEN WINDUNGSZAHL EINER REGELWICKLUNG IN EINER ELEKTRISCHEN ANLAGE UND ELEKTRISCHE ANLAGE MIT EINER REGELWICKLUNG**
METHOD FOR CHANGING THE ACTIVE NUMBER OF TURNS OF A CONTROL WINDING IN AN ELECTRIC SYSTEM, AND ELECTRIC SYSTEM COMPRISING A CONTROL WINDING
PROCÉDÉ PERMETTANT DE MODIFIER LE NOMBRE DE SPIRES ACTIVES D'UN ENROULEMENT DE RÉGULATION DANS UNE INSTALLATION ÉLECTRIQUE ET INSTALLATION ÉLECTRIQUE MUNIE D'UN ENROULEMENT DE RÉGULATION

(30) Priorität: 25.02.2015 DE 102015102727
(43) Veröffentlichungstag der Anmeldung: 03.01.2018
(73) Patentinhaber: Maschinenfabrik Reinhausen GmbH, 93059 Regensburg (DE)
(72) Erfinder: SAVELIEV, Anatoli, 93197 Zeitlarn (DE); STERZ, Oliver, 93047 Regensburg (DE)
(86) Internationale Anmeldenummer: PCT/EP2016/053225
(87) Internationale Veröffentlichungsnummer: WO 2016/135003

(56) Entgegenhaltungen:
- EP-A1- 2 541 572
- DE-A1- 2 021 575
- DE-U1-202012 101 039
- JP-A- H0 795 723

## Beschreibung

Die Erfindung betrifft ein Verfahren zum Ändern der aktiven Windungszahl einer Regelwicklung in einer elektrischen Anlage und eine elektrische Anlage mit einer Regelwicklung.

EP 2 541 572 A1 beschreibt zum Einen einen Laststufenschalter zum Verbinden mit einer Regelwicklung eines Transformators. Dieser Laststufenschalter umfasst einen Wähler und einen an den Wähler angeschlossenen Lastumschalter. Der Wähler umfasst mehrere Festkontakte, die an zugeordnete Anzapfungen der Regelwicklung angeschlossen sind, zwei Bewegtkontakte und zu jedem Bewegtkontakt einen Stromsammler. Jeder Bewegtkontakt ist mit einem Ende an dem jeweiligen Stromsammler angeschlossen und kann längs des Stromsammlers in unterschiedliche Positionen bewegt werden, in denen er an seinem anderen Ende mit einem zugeordneten Festkontakt elektrisch verbunden ist. Der Lastumschalter umfasst zwei Zweige, von denen jeder eine Reihenschaltung aus einem Haupttrennschalter und einem Übergangstrennschalter sowie einen Übergangswiderstand, der parallel zu dem Haupttrennschalter geschaltet ist, umfasst. Wegen dieser Reihenschaltung wird dieser Lastumschalter auch als Reihen-Lastumschalter bezeichnet. Jeder Zweig ist zwischen einen Außenkontakt und einen zugeordneten Stromsammler geschaltet. Der Haupttrennschalter ist derart geschaltet, dass er elektrisch näher zu dem Außenkontakt liegt als der Übergangstrennschalter. Die Übergangswiderstände sind an den Außenkontakt über eine gemeinsame Leitung angeschlossen. Der Laststufenschalter umfasst weiterhin wenigstens einen Stromdetektor und einen Fehlerdetektor. Jeder Stromdetektor ist dazu hergerichtet, einen Strom, der durch einen Pfad des Lastumschalters fließt, zu erfassen und als Antwort auf den erfassten Strom ein Stromanzeigesignal zu erzeugen. Der Fehlerdetektor ist dazu hergerichtet, das Stromanzeigesignal von dem Stromdetektor zu erhalten, basierend auf dem empfangenen Stromanzeigesignal zu bestimmen, ob in dem Lastumschalter ein Fehler aufgetreten ist, und ein Fehleranzeigesignal zu erzeugen, falls bestimmt wurde, dass in dem Lastumschalter ein Fehler aufgetreten ist. Der Fehlerdetektor ist dazu hergerichtet, zu bestimmen, ob ein Übergangstrennschalter es versäumt hat zu öffnen, indem er bestimmt, ob die Zeitdauer des Stromanzeigesignals einen ersten Schwellenwert übersteigt. Der Fehlerdetektor ist dazu hergerichtet, zu bestimmen, ob ein Haupttrennschalter es versäumt hat zu öffnen, indem er bestimmt, ob die Zeitdauer des Stromanzeigesignals kürzer als ein zweiter Schwellenwert ist. Jeder Stromdetektor ist eine Strommessvorrichtung, die mithilfe des Stromanzeigesignals eine Stärke eines erfassten Stroms anzeigt, und der Fehlerdetektor ist dazu hergerichtet, die Stärke des erfassten Stroms bei der Bestimmung, ob ein Fehler aufgetreten ist, zu berücksichtigen. Der Stromdetektor ist dazu hergerichtet, den Strom, der durch die gemeinsame Leitung fließt, zu erfassen. Der Lastumschalter umfasst je Zweig einen Stromdetektor, der dazu hergerichtet ist, den Strom, der durch den Übergangswiderstand dieses Zweigs fließt, zu erfassen, sowie je Zweig einen Stromdetektor, der dazu hergerichtet ist, den Strom, der durch den Übergangstrennschalter dieses Zweigs fließt, zu erfassen. Der Fehlerdetektor ist dazu hergerichtet, zu bestimmen, ob ein Übergangstrennschalter es versäumt hat zu öffnen, indem er prüft, ob eine Zeitperiode, während der ein Stromanzeigesignal von dem Stromdetektor aus zwei Zweigen empfangen wird, einen dritten Schwellenwert übersteigt. Der Fehlerdetektor ist mit einem Auslösemechanismus eines Transformatorschutzschalters verbunden, sodass der Transformator, an den der Stufenschalter angeschlossen ist, vom Netz getrennt werden kann, falls ein schwerwiegender Fehler, typischerweise ein Fehler in einem Übergangstrennschalter, detektiert werden sollte.

EP 2 541 572 A1 beschreibt zum Anderen ein Verfahren zum Betreiben eines Laststufenschalters mit einem Lastumschalter, der zwei Zweige umfasst. Jeder Zweig umfasst eine Reihenschaltung aus einem Haupttrennschalter und einem Übergangstrennschalter und einen Übergangswiderstand, der parallel zu dem Haupttrennschalter geschaltet ist. Dieses Verfahren umfasst die Schritte, dass
- wenigstens ein Pfad des Lastumschalters überwacht wird, um den Strom, der durch den Pfad fließt, zu erfassen;
- als Antwort auf den Strom, der durch den Pfad fließt, ein Stromanzeigesignal erzeugt wird;
- basierend auf dem erzeugten Stromanzeigesignal bestimmt wird, ob in dem Lastumschalter ein Fehler aufgetreten ist;
- ein Fehleranzeigesignal erzeugt wird, falls bestimmt wurde, dass in dem Lastumschalter ein Fehler aufgetreten ist.

Das Überwachen mindestens eines Pfades umfasst, dass überwacht wird, ob ein Strom durch einen Übergangswiderstand fließt. Das Bestimmen umfasst, dass bestimmt wird, ob die Zeitdauer eines empfangenen Stromanzeigesignals einen ersten Schwellenwert übersteigt und kürzer als ein zweiter Schwellenwert ist.

Das Verfahren umfasst den Schritt, dass die Stärke eines erfassten Stroms bestimmt wird. Das Bestimmen, ob ein Fehler aufgetreten ist, erfolgt in Abhängigkeit von der bestimmten Größe des erfassten Stroms. Das Überwachen mindestens eines Pfade umfasst, dass für jeden Zweig überwacht wird, ob ein Strom durch den Übergangstrennschalter dieses Zweigs fließt. Das Bestimmen, ob ein Fehler aufgetreten ist, umfasst, dass geprüft wird, ob eine Zeitperiode, während der ein Stromanzeigesignal von dem Stromdetektor aus zwei Zweigen empfangen wird, einen dritten Schwellenwert übersteigt. Die Schwellenwerte sind vorbestimmt.

EP 2 541 572 A1 beschreibt, dass der Laststufenschalter zum Ändern der aktiven Windungszahl des Transformators von einem ersten Dauerstromzustand zu einem zweiten Dauerstromzustand umschaltet. In dem ersten Dauerstromzustand fließt der Strom von einer ersten Anzapfung durch den ersten Bewegtkontakt, den ersten Stromsammler und den ersten Übergangstrennschalter und den ersten Haupttrennschalter des ersten Zweigs zu dem Außenkontakt und ist eine zweite Anzapfung von dem Außenkontakt getrennt. In dem zweiten Dauerstromzustand fließt der Strom von einer zweiten Anzapfung durch den zweiten Bewegtkontakt, den zweiten Stromsammler und den zweiten Übergangstrennschalter und den zweiten Haupttrennschalter des zweiten Zweigs zu dem Außenkontakt und ist die erste Anzapfung von dem Außenkontakt getrennt. Ausgehend von dem ersten Dauerstromzustand wird der erste Haupttrennschalter geöffnet, sodass der Strom nun durch den ersten Übergangswiderstand des ersten Zweigs sowie den ersten Übergangstrennschalter fließt. Danach wird der zweite Übergangstrennschalter geschlossen, sodass der Lastumschalter nun zwei geschlossenen Zweige für den Stromfluss hat, wobei der Strom in jedem Zweig durch einen Übergangswiderstand begrenzt wird. Danach wird der erste Übergangstrennschalter geöffnet, sodass nun der gesamte Strom durch den zweiten Übergangswiderstand sowie den zweiten Übergangstrennschalter fließt und weiterhin durch den zweiten Übergangswiderstand begrenzt wird. Schließlich wird der zweite Haupttrennschalter geschlossen, sodass nun der Strom durch den zweiten Haupttrennschalter und den zweiten Übergangstrennschalter fließt und der zweite Dauerstromzustand erreicht ist.

Somit bildet jede Reihenschaltung aus Übergangstrennschalter und Haupttrennschalter einen Hauptpfad, und bildet jede Reihenschaltung aus Übergangstrennschalter und Übergangswiderstand, der parallel zum Haupttrennschalter geschaltet ist, einen Übergangspfad.

DE 20 21 575 A1 beschreibt einen Lastumschalter mit zwei Zweigen, von denen jeder eine Parallelschaltung aus einer ersten Vakuumschaltröhre und einer Reihenschaltung aus einem Übergangswiderstand und einer zweiten Vakuumschaltröhre umfasst. Wegen dieser Parallelschaltung wird dieser Lastumschalter auch als Parallel-Lastumschalter bezeichnet. In jedem Zweig bildet die erste Vakuumschaltröhre einen Hauptpfad und bildet die Reihenschaltung einen Übergangspfad.

DE 42 31 353 A1 beschreibt einen Lastumschalter mit zwei Vakuumschaltröhren, einem Übergangswiderstand und einem Umschalter, der zwei Umschaltkontakte sowie einen Mittelkontakt umfasst. Die erste Vakuumschaltröhre ist zwischen Mittelkontakt und Lastableitung geschaltet. Der erste Umschaltkontakt ist an einen ersten Bewegtkontakt eines Wählers angeschlossen, der zweite Umschaltkontakt an einen zweiten Bewegtkontakt. Eine Reihenschaltung aus Übergangswiderstand und zweiter Vakuumschaltröhre ist zwischen zweiten Bewegtkontakt und Lastableitung geschaltet und somit parallel zu erster Vakuumschaltröhre, Mittelkontakt und zweitem Umschaltkontakt. Die erste Vakuumschaltröhre, der Mittelkontakt und der erste Umschaltkontakt bilden einen ersten Hauptpfad, die Reihenschaltung bildet einen Übergangspfad, und die erste Vakuumschaltröhre, der Mittelkontakt und der zweite Umschaltkontakt bilden einen zweiten Hauptpfad.

DE 42 31 353 A1 beschreibt außerdem einen Lastumschalter mit zwei Zweigen, von denen einer eine erste Vakuumschaltröhre und der andere eine Parallelschaltung aus einer zweiten Vakuumschaltröhre und einer Reihenschaltung aus einem Übergangswiderstand und einer dritten Vakuumschaltröhre umfasst. Die erste Vakuumschaltröhre bildet einen ersten Hauptpfad, die Reihenschaltung bildet einen Übergangspfad, und die zweite Vakuumschaltröhre bildet einen zweiten Hauptpfad.

DE 10 2007 004 530 A1 beschreibt einen Lastumschalter mit drei Vakuumschaltröhren, zwei Übergangswiderständen und einem Umschalter, der zwei Umschaltkontakte sowie einen Mittelkontakt umfasst. Die erste Vakuumschaltröhre ist zwischen Mittelkontakt und Lastableitung geschaltet. Der erste Umschaltkontakt ist an einen ersten Bewegtkontakt eines Wählers angeschlossen, der zweite Umschaltkontakt an einen zweiten Bewegtkontakt. Eine erste Reihenschaltung aus erstem Übergangswiderstand und zweiter Vakuumschaltröhre ist zwischen ersten Bewegtkontakt und Lastableitung geschaltet und somit parallel zu erster Vakuumschaltröhre, Mittelkontakt und erstem Umschaltkontakt. Eine zweite Reihenschaltung aus zweiten Übergangswiderstand und dritter Vakuumschaltröhre ist zwischen zweiten Bewegtkontakt und Lastableitung geschaltet und somit parallel zu erster Vakuumschaltröhre, Mittelkontakt und zweiten Umschaltkontakt. Die erste Vakuumschaltröhre, der Mittelkontakt und der erste Umschaltkontakt bilden einen ersten Hauptpfad, die erste Reihenschaltung bildet einen ersten Übergangspfad, die zweite Reihenschaltung bildet einen zweiten Übergangspfad, und die erste Vakuumschaltröhre, der Mittelkontakt und der zweite Umschaltkontakt bilden einen zweiten Hauptpfad.

Vor diesem Hintergrund schlägt die Erfindung die Gegenstände der unabhängigen Ansprüche vor. Vorteilhafte Weiterbildungen und Ausführungsformen der Erfindung sind in den abhängigen Ansprüchen beschrieben.

Die Erfindung schlägt gemäß einem ersten Aspekt ein Verfahren zum Ändern der aktiven Windungszahl einer Regelwicklung in einer elektrischen Anlage vor, wobei
- die Regelwicklung an ein Wechselstromnetz mit einer vorgegebenen Periodendauer T gekoppelt ist, für eine vorgegebene Nennstromstärke IN ausgelegt ist und eine erste und eine zweite Anzapfung umfasst;
- von einem ersten Dauerstromzustand, in dem ein Laststrom von der ersten Anzapfung über einen ersten Hauptpfad zu einer Lastableitung fließt und die zweite Anzapfung von der Lastableitung getrennt ist, gemäß einem vorgegebenen Schaltablaufplan zu einem zweiten Dauerstromzustand, in dem der Laststrom von der zweiten Anzapfung über einen zweiten Hauptpfad zu der Lastableitung fließt und die erste Anzapfung von der Lastableitung getrennt ist, umgeschaltet wird;
- der Schaltablaufplan vorschreibt, dass
   - ausgehend von dem ersten Dauerstromzustand in einem Schaltschritt a die erste Anzapfung über einen ersten Übergangspfad mit der Lastableitung verbunden ist oder bleibt oder wird und der erste Hauptpfad getrennt wird;
   - nach Schaltschritt a in einem Schaltschritt b die zweite Anzapfung über einen zweiten Übergangspfad mit der Lastableitung verbunden wird, sodass aufgrund der Stufenspannung zwischen der ersten und der zweiten Anzapfung ein Kreisstrom iK durch die Übergangspfade fließt;
   - nach Schaltschritt b in einem Schaltschritt c die erste Anzapfung von der Lastableitung getrennt wird;
   - nach Schaltschritt c in einem Schaltschritt d die zweite Anzapfung über den zweiten Hauptpfad mit der Lastableitung verbunden wird;
- zu wenigstens einem vorgegebenen Test-Zeitpunkt tT zwischen Schaltschritt a und Schaltschritt c getestet wird, ob der erste Hauptpfad getrennt ist;
- eine Stromstärke IL des Laststroms ermittelt wird;
- der Test-Zeitpunkt tT von der Laststromstärke IL abhängt.

Mit diesem vorgeschlagenen Verfahren wird somit das ordnungsgemäße Trennen des ersten Hauptpfads überwacht.

Dieses Verfahren ermöglicht eine einfache Anpassung an unterschiedliche Laststromstärken und somit unterschiedliche Betriebszustände sowie eine einfach zu realisierende und zuverlässige Fehlerüberwachung der Stromtrennungen, die beim Ändern der aktiven Windungszahl erforderlich sind.

Außerdem ermöglicht dieses Verfahren die Verwendung eines Stromsensors, der eine beliebige - beispielsweise nicht-lineare und/oder monotone - Übertragungsfunktion und/oder eine beliebige - beispielsweise nicht-lineare und/oder monotone - Messkennlinie und/oder eine geringe Genauigkeit und/oder eine schlechte zeitliche Stabilität und/oder einen schwankenden oder nicht genau definierten Erfassungsschwellenwert hat und/oder ein einfaches EIN/AUS-Messsignal liefert, je nachdem, ob die momentane Stromstärke des zu erfassenden Stroms den Erfassungsschwellenwert des Stromsensors überschreitet oder nicht. Ein derartiger Stromsensor umfasst beispielsweise einen Sättigungsstromwandler und ist somit sehr einfach konstruiert und daher auch sehr preisgünstig. Vorteilhafterweise hat der Stromsensor eine ausreichend gute zeitliche Auflösung von beispielsweise besser als 0,01T oder 0,005T oder 0,002T oder 0,001T, was jedoch für die derzeit erhältlichen Stromsensoren kein Problem darstellt.

Des Weiteren ist dieses Verfahren sowohl für elektrische Anlagen, die einen Reihen-Lastumschalter umfassen, geeignet als auch für elektrische Anlagen, die einen Lastumschalter umfassen, der anders als ein Reihen-Lastumschalter ausgebildet ist. Derartige anders ausgebildete Lastumschalter können beispielsweise nur einen Übergangswiderstand, Übergangsdrosseln anstelle von Übergangswiderständen, mehr oder weniger als vier Trennschalter oder in einem Zweig zwei parallele Trennschalter umfassen.

Vorzugsweise umfasst das Trennen der ersten Anzapfung von der Lastableitung in Schaltschritt c, dass der erste Übergangspfad getrennt wird.

Die Laststromstärke kann nach Bedarf beliebig gewählt sein, beispielsweise als die Amplitude des Laststroms, falls dieser sinusförmig ist, oder der Scheitelwert des Laststroms, falls dieser eine Wechselgröße ist, oder der Effektivwert des Laststroms, falls dieser eine Wechselgröße ist, oder der Spitze-Tal-Wert des Laststroms, falls dieser einen beliebigen periodischen Verlauf hat, oder der Maximalwert des Laststroms, falls dieser einen beliebigen periodischen Verlauf hat, oder als ein Mittelwert einer der vorstehenden Größen.

Dieser Mittelwert, auch als mittlere Laststromstärke bezeichnet, kann nach Bedarf beliebig gewählt sein, beispielsweise als Median oder arithmetisches Mittel oder geometrisches Mittel oder harmonisches Mittel oder quadratisches Mittel oder kubisches Mittel oder logarithmisches Mittel, und nach Bedarf beispielsweise gestutzt oder winsorisiert oder gewichtet oder gleitend sein.

Das Ermitteln der mittleren Laststromstärke kann nach Bedarf auf beliebige Art und Weise erfolgen, beispielsweise über wenigstens eine Periodendauer und/oder über höchstens 10 Periodendauern und/oder vor oder nach Erzeugen eines Schaltsignals zum Umschalten von dem ersten Dauerstromzustand zu dem zweiten Dauerstromzustand. Dieses Schaltsignal wird beispielhaft von einer Steuereinrichtung der Anlage erzeugt.

Diese Steuereinrichtung umfasst bei einer beispielhaften Anlage, die einen Regeltransformator mit einer Primärseite und einer Sekundärseite umfasst und bei der die Regelwicklung zumindest einen Teil der Primärseite oder der Sekundärseite bildet, beispielsweise einen Spannungsregler, dessen Aufgabe es ist, die Primärspannung oder die Sekundärspannung des Regeltransformators in einem vorbestimmten Spannungsband zu halten.

Diese Steuereinrichtung umfasst bei einer beispielhaften Anlage, die eine regelbare oder variable Kompensationsdrossel zum Liefern von induktiver Blindleistung in das Wechselstromnetz und/oder zum Kompensieren von kapazitiver Blindleistung aus dem Wechselstromnetz umfasst und bei der die Regelwicklung zumindest einen Teil der Kompensationsdrossel bildet, beispielsweise einen Blindleistungsregler, dessen Aufgabe es ist, die von der Kompensationsdrossel zu liefernde und/oder zu kompensierende Blindleistung einzustellen und/oder die Blindleistung des Wechselstromnetzes in einem vorbestimmten Blindleistungsband zu halten.

Jede dieser beiden Anlagen umfasst beispielhaft einen an die Steuereinrichtung gekoppelten und mit der Regelwicklung verbundenen Laststufenschalter mit einem Lastumschalter und einem Feinwähler, der für die Regelwicklung zwei Bewegtkontakte und zu jeder Anzapfung einen mit dieser elektrisch leitend verbundenen Festkontakt umfasst. Bei einem derartigen Laststufenschalter erfolgt die leistungslose oder stromlose oder lastfreie Vorwahl des stromlosen Festkontaktes der zweiten Anzapfung, auf die umgeschaltet werden soll, mit Hilfe desjenigen Bewegtkontaktes des Feinwählers, der nicht an dem stromführenden Festkontakt der ersten Anzapfung, durch die der Laststrom fließt, anliegt und stromlos oder nicht stromführend ist, und die eigentliche Umschaltung unter Last von dem anderen Bewegtkontakt, der an dem stromführenden Festkontakt anliegt und stromführend ist, zu dem stromlosen Bewegtkontakt im Lastumschalter. Das Schaltsignal enthält bei dieser Ausführungsform beispielhaft Informationen darüber, welcher Bewegtkontakt des Feinwählers bewegt werden soll und welcher Festkontakt des Feinwählers von diesem zu bewegenden Bewegtkontakt beschaltet werden soll.

Das Ermitteln der Laststromstärke erfolgt bevorzugt vor Schaltschritt a.

Dieses Verfahren ist bevorzugt symmetrisch ausgelegt, sodass es beim Umschalten in der umgekehrten Richtung, also von dem zweiten zu dem ersten Dauerstromzustand, analog das ordnungsgemäße Trennen des zweiten Hauptpfads überwacht.

Vorzugsweise ist vorgesehen, dass
- das Testen umfasst, dass
   - der Strom i1, der im ersten Hauptpfad fließt, erfasst wird und mit einem vorgegebenen Erfassungsschwellenwert verglichen wird;
   - bei Unterschreiten das Testergebnis als positiv und andernfalls als negativ gewertet wird.

Vorzugsweise ist vorgesehen, dass
- der Test-Zeitpunkt tT eine vorgegebene Verzögerungszeit TV nach Beginn des Schaltschritts a liegt.

Vorzugsweise ist vorgesehen, dass
- der Test-Zeitpunkt tT vor Schaltschritt b liegt.

Vorzugsweise ist vorgesehen, dass
- vor dem Testen, und insbesondere vor Schaltschritt a, die Laststromstärke IL mit einem vorgegebenen Modusschwellenwert verglichen wird;
- bei Überschreiten das Testen gemäß einem Modus A und andernfalls gemäß einem Modus B ausgeführt wird oder bei Unterschreiten das Testen gemäß einem Modus B und andernfalls gemäß einem Modus A ausgeführt wird.

Vorzugsweise ist vorgesehen, dass der Modusschwellenwert
- von dem Erfassungsschwellenwert und/oder dem unteren Schwellenwert und/oder der Nennstromstärke IN und/oder der Kreisstromstärke IK abhängt; und/oder
- größer oder gleich dem Erfassungsschwellenwert und/oder dem unteren Schwellenwert ist; und/oder
- höchstens um einen vorgegebenen Anteil größer als der Erfassungsschwellenwert und/oder der untere Schwellenwert ist, und dieser Anteil bevorzugt 5% oder 7% oder 10% oder 12% oder 15% oder 20% oder 25% oder 30% oder 35% oder 40% oder 45% oder 50% oder 60% oder 80% oder 100% oder 120% oder 150% oder 200% oder 250% oder 300% beträgt; und/oder
- kleiner als der obere Schwellenwert ist; und/oder
- kleiner oder gleich einem vorgegebenen Anteil der Kreisstromstärke IK ist, und dieser Anteil bevorzugt 60% oder 50% oder 40% oder 30% oder 25% oder 20% oder 17% oder 15% oder 12% oder 11% oder 10% oder 7% oder 5% beträgt;
- kleiner oder gleich einem vorgegebenen Anteil der Nennstromstärke IN ist, und dieser Anteil bevorzugt 25% oder 20% oder 17% oder 15% oder 12% oder 11% oder 10% oder 7% oder 5% beträgt.

### Testmodus A:

Vorzugsweise ist vorgesehen, dass in Modus A
- der Test-Zeitpunkt tT vor Schaltschritt b liegt.

### Testmodus B:

Vorzugsweise ist vorgesehen, dass in Modus B
- der Test-Zeitpunkt tT nach Schaltschritt b liegt.

Vorzugsweise ist vorgesehen, dass das Testen umfasst, dass
- der Strom i2, der im ersten Übergangspfad fließt, erfasst wird und mit einem vorgegebenen unteren Kreisstromschwellenwert verglichen wird;
- bei Überschreiten das Testergebnis als positiv und andernfalls als negativ gewertet wird.

Vorzugsweise ist vorgesehen, dass
- das Testen umfasst, dass
   - der Strom i3, der im zweiten Übergangspfad oder durch die erste oder zweite Anzapfung fließt, erfasst wird und mit einem vorgegebenen oberen Kreisstromschwellenwert verglichen wird;
- bei Unterschreiten das Testergebnis als positiv und andernfalls als negativ gewertet wird.

Vorzugsweise ist vorgesehen, dass der untere Kreisstromschwellenwert
- von der Nennstromstärke IN und/oder der Kreisstromstärke IK und/oder der Laststromstärke IL abhängt; und/oder
- von dem Widerstandswert eines ersten Übergangswiderstands, der in den ersten Übergangspfad geschaltet ist, und/oder dem Widerstandswert eines zweiten Übergangswiderstands, der in den zweiten Übergangspfad geschaltet ist, abhängt;
- kleiner oder gleich einem vorgegebenen Anteil der Kreisstromstärke IK ist, und dieser Anteil bevorzugt 60% oder 50% oder 40% oder 30% oder 25% oder 20% oder 17% oder 15% oder 12% oder 11% oder 10% oder 7% oder 5% beträgt;
- kleiner oder gleich einem vorgegebenen maximalen Anteil der Nennstromstärke IN und/oder größer oder gleich einem vorgegebenen minimalen Anteil der Nennstromstärke IN ist, und der maximale Anteil bevorzugt 60% oder 55% oder 50% oder 45% oder 40% oder 35% oder 30% und/oder der minimale Anteil bevorzugt 50% oder 45% oder 40% oder 35% oder 30% oder 25% oder 20% beträgt.

Vorzugsweise ist vorgesehen, dass der obere Kreisstromschwellenwert
- von der Nennstromstärke IN und/oder der Kreisstromstärke IK und/oder der Laststromstärke IL abhängt; und/oder
- von dem Widerstandswert eines ersten Übergangswiderstands, der in den ersten Übergangspfad geschaltet ist, und/oder dem Widerstandswert eines zweiten Übergangswiderstands, der in den zweiten Übergangspfad geschaltet ist, abhängt;
- größer als der untere Kreisstromschwellenwert ist; und/oder
- kleiner oder gleich einem vorgegebenen Anteil der Kreisstromstärke IK ist, und dieser Anteil bevorzugt 90% oder 80% oder 70% oder 60% oder 55% oder 50% oder 45% oder 40% beträgt;
- kleiner oder gleich einem vorgegebenen Anteil der Nennstromstärke IN ist, und dieser Anteil bevorzugt 80% oder 75% oder 70% oder 65% oder 60% oder 55% oder 50% oder 45% oder 40% oder 35% oder 30% oder 25% oder 20% beträgt.

Vorzugsweise ist vorgesehen, dass
- der Test-Zeitpunkt tT eine vorgegebene Verzögerungszeit TV nach Beginn des Schaltschritts b liegt.

Allgemeine Unteransprüche für Hauptpfad
Vorzugsweise ist vorgesehen, dass
- der Test-Zeitpunkt tT und/oder die Verzögerungszeit TV von dem ersten Nulldurchgang tN des Laststroms seit Beginn des Schaltschritts a abhängt.

Vorzugsweise ist vorgesehen, dass
- das Testen in einem Test-Zeitintervall TT erfolgt, das von dem ersten Nulldurchgang tN des Laststroms seit Beginn des Schaltschritts a bis zu dem Test-Zeitpunkt tT reicht; und/oder
- das Testen nach oder ab dem ersten Nulldurchgang tN des Laststroms seit Beginn des Schaltschritts a und bis zu dem Test-Zeitpunkt tT erfolgt.

Die Erfindung schlägt gemäß einem zweiten Aspekt ein Verfahren, das insbesondere gemäß dem ersten Aspekt ausgebildet ist, zum Ändern der aktiven Windungszahl einer Regelwicklung in einer elektrischen Anlage vor, wobei
- die Regelwicklung an ein Wechselstromnetz mit einer vorgegebenen Periodendauer T gekoppelt ist, für eine vorgegebene Nennstromstärke IN ausgelegt ist und eine erste und eine zweite Anzapfung umfasst;
- von einem ersten Dauerstromzustand, in dem ein Laststrom von der ersten Anzapfung über einen ersten Hauptpfad zu einer Lastableitung fließt und die zweite Anzapfung von der Lastableitung getrennt ist, gemäß einem vorgegebenen Schaltablaufplan zu einem zweiten Dauerstromzustand, in dem der Laststrom von der zweiten Anzapfung über einen zweiten Hauptpfad zu der Lastableitung fließt und die erste Anzapfung von der Lastableitung getrennt ist, umgeschaltet wird;
- der Schaltablaufplan vorschreibt, dass
   - ausgehend von dem ersten Dauerstromzustand in einem Schaltschritt a die erste Anzapfung über einen ersten Übergangspfad mit der Lastableitung verbunden ist oder bleibt oder wird und der erste Hauptpfad getrennt wird;
   - nach Schaltschritt a in einem Schaltschritt b die zweite Anzapfung über einen zweiten Übergangspfad mit der Lastableitung verbunden wird, sodass aufgrund der Stufenspannung zwischen der ersten und der zweiten Anzapfung ein Kreisstrom iK durch die Übergangspfade fließt;
   - nach Schaltschritt b in einem Schaltschritt c der erste Übergangspfad getrennt wird;
   - nach Schaltschritt c in einem Schaltschritt d die zweite Anzapfung über den zweiten Hauptpfad mit der Lastableitung verbunden wird;
- zu wenigstens einem vorgegebenen Test-Zeitpunkt tT zwischen Schaltschritt c und Schaltschritt d getestet wird, ob der erste Übergangspfad getrennt ist;
- eine Stromstärke IL des Laststroms ermittelt wird;
- der Test-Zeitpunkt tT von der Laststromstärke IL abhängt.

Mit diesem vorgeschlagenen Verfahren wird somit das ordnungsgemäße Trennen des ersten Übergangspfads überwacht.

Vorzugsweise wird in Schaltschritt c durch das Trennen des ersten Übergangspfads die erste Anzapfung von der Lastableitung getrennt oder wird zwischen Schaltschritten c und d die erste Anzapfung von der Lastableitung getrennt.

Dieses Verfahren ist bevorzugt symmetrisch ausgelegt, sodass es beim Umschalten in der umgekehrten Richtung, also von dem zweiten zu dem ersten Dauerstromzustand, analog das ordnungsgemäße Trennen des zweiten Übergangspfads überwacht.

Das Trennen der ersten Anzapfung von der Lastableitung erfolgt bevorzugt entweder in Schaltschritt c oder zwischen Schaltschritt c und d.

Vorzugsweise ist vorgesehen, dass das Testen umfasst, dass
- der Strom i2, der im ersten Übergangspfad fließt, erfasst wird und mit einem vorgegebenen Erfassungsschwellenwert verglichen wird;
- bei Unterschreiten das Testergebnis als positiv und andernfalls als negativ gewertet wird.

Falls wenigstens zwei Testergebnisse vorliegen, beispielsweise ein Testergebnis von dem Testen des Stroms i1 im ersten Hauptpfad und/oder ein Testergebnis von dem Testen des Stroms i2 im ersten Übergangspfad und/oder ein Testergebnis von dem Testen des Stroms i3 im zweiten Übergangspfad oder durch die erste oder zweite Anzapfung, dann wird bevorzugt ein Gesamttestergebnis als negativ gewertet, falls auch nur eines der Testergebnisse negativ sein sollte, und/oder wird das Gesamttestergebnis als positiv gewertet, solange alle Testergebnisse positiv und/oder nicht negativ sind.

Vorzugsweise ist vorgesehen, dass
- der Test-Zeitpunkt tT eine vorgegebene Verzögerungszeit TV nach Beginn des Schaltschritts c liegt.

Vorzugsweise ist vorgesehen, dass
- der Test-Zeitpunkt tT vor oder kurz nach Schaltschritt d liegt.

Die Zeitspanne, um die der Test-Zeitpunkt tT kurz nach Schaltschritt d liegt, hängt vorteilhafterweise von der Auslegung der Übergangswiderstände ab.

Vorzugsweise ist vorgesehen, dass
- der Test-Zeitpunkt tT und/oder die Verzögerungszeit TV von dem ersten Nulldurchgang tN des Laststroms seit Beginn des Schaltschritts c abhängt.

Vorzugsweise ist vorgesehen, dass
- das Testen in einem Test-Zeitintervall TT erfolgt, das von dem ersten Nulldurchgang tN des Laststroms seit Beginn des Schaltschritts c bis zu dem Test-Zeitpunkt tT reicht; und/oder
- das Testen nach oder ab dem ersten Nulldurchgang tN des Laststroms seit Beginn des Schaltschritts c und bis zu dem Test-Zeitpunkt tT erfolgt.

Vorzugsweise ist vorgesehen, dass
- der Schaltablaufplan vorschreibt, dass
   - in Schaltschritt a der erste Hauptpfad getrennt wird, indem ein erster Trennschalter in dem ersten Hauptpfad geöffnet wird; und/oder
   - in Schaltschritt c die erste Anzapfung von der Lastableitung getrennt wird, indem der erste Übergangspfad getrennt wird, insbesondere indem ein zweiter Trennschalter in dem ersten Übergangspfad geöffnet wird; und/oder
   - durch/nach Schaltschritt d der zweite Dauerstromzustand erreicht wird.

Vorzugsweise ist vorgesehen, dass
- das Testen des ersten Hauptpfads dadurch erfolgt, dass das Öffnen des ersten Trennschalters getestet wird; und/oder
- das Testen des ersten Übergangspfads dadurch erfolgt, dass das Öffnen des zweiten Trennschalters getestet wird; und/oder
- wenigstens einer der Trennschalter als Ölschalter oder als Vakuumschaltröhre ausgebildet ist; und/oder
- wenigstens einer der Trennschalter mithilfe eines Direktantriebs betätigt wird.

Als Direktantrieb wird hier ein Antrieb verstanden, der beispielsweise für einen Laststufenschalter mit mehreren Trennschaltern bekannt ist und beispielhaft für jeden Trennschalter einen eigenen, separaten Motor umfasst, dessen Bewegung direkt und/oder unmittelbar und/oder verzögerungsfrei eine Bewegung und/oder Betätigung des jeweiligen Trennschalters bewirkt, oder für jeweils wenigstens zwei Trennschalter beziehungsweise für jede Gruppe aus wenigstens zwei Trennschaltern ein gemeinsames Steuergetriebe und einen gemeinsamen Motor umfasst, dessen Bewegung direkt und/oder unmittelbar und/oder verzögerungsfrei eine Bewegung und/oder Betätigung des jeweiligen gemeinsamen Steuergetriebes bewirkt. Ein Direktantrieb ermöglicht somit auf einfache Weise eine positive und negative Beschleunigung bis hin zur Richtungsumkehr der Bewegung der zugeordneten Trennschalter beziehungsweise Steuergetriebe.

Im Unterschied hierzu ist für einen Laststufenschalter mit mehreren Trennschaltern ein Antrieb bekannt, der für alle Trennschalter einen gemeinsamen Motor, einen gemeinsamen Federenergiespeicher und ein gemeinsames Steuergetriebe umfasst. Das Steuergetriebe umfasst üblicherweise eine Kurvenscheibe, die von dem Motor angetrieben und deren Kurve von den Trennschaltern abgetastet wird, sodass diese in einer durch die Form der Kurve vorbestimmten zeitlichen Abfolge betätigt werden. Der Federenergiespeicher ist eingangsseitig an den Motor und ausgangsseitig an das Steuergetriebe derart gekoppelt, dass die Bewegung des Motors zwar direkt und unmittelbar eine Bewegung des Federenergiespeichers bewirkt, sodass dessen Feder gespannt wird, dass jedoch das Steuergetriebe und die Kurvenscheibe und somit auch die Trennschalter während dieser Spannphase nicht bewegt werden. Erst nachdem die Feder eine vorbestimmte Spannung erreicht hat, wird der Federenergiespeicher ausgelöst, sodass sich die Feder schlagartig entspannt und erst diese Bewegung der Feder direkt und unmittelbar eine entsprechend schnelle Bewegung des Steuergetriebes und der Kurvenscheibe bewirkt.

Vorzugsweise ist vorgesehen, dass
- das Ändern der aktiven Windungszahl mithilfe eines Laststufenschalters erfolgt, der an die Anzapfungen der Regelwicklung angeschlossen ist.

Vorzugsweise ist vorgesehen, dass der Laststufenschalter
- mithilfe eines Direktantriebs angetrieben wird; und/oder
- wenigstens einen der Trennschalter umfasst.

Vorzugsweise ist vorgesehen, dass
- die Verzögerungszeit TV von der Laststromstärke IL abhängt.

Die Verzögerungszeit TV hängt von der Laststromstärke IL bevorzugt monoton fallend oder antiton ab.

Vorzugsweise ist, insbesondere in Modus A, vorgesehen, dass
- die Laststromstärke IL mit einem vorgegebenen oberen Schwellenwert verglichen wird;
- bei Überschreiten die Verzögerungszeit tV auf einen vorgegebenen Wert TV1 und andernfalls auf einen vorgegebenen Wert TV2>TV1 gesetzt wird.

Das Vergleichen der Laststromstärke IL mit dem oberen Schwellenwert erfolgt bevorzugt vor Schaltschritt a oder b, in Modus A bevorzugt vor Schaltschritt a und in Modus b bevorzugt vor Schaltschritt a oder b.

Vorzugsweise ist, insbesondere in Modus A, vorgesehen, dass
- TV1 und/oder TV2 von der Laststromstärke IL und/oder von einer Trenndauer DT des Trennens abhängt.

Als Trenndauer eines Pfads wird die Dauer verstanden, die für das vollständige Trennen dieses Pfads benötigt wird. Falls dieses Trennen beispielsweise mithilfe eines Trennschalters erfolgt, dann wird die Trenndauer durch die Dauer bestimmt, die für das vollständige Öffnen des Trennschalters benötigt wird.

Vorzugsweise ist, insbesondere in Modus A, vorgesehen, dass
- ein erster Zeitpuffer TY1 und ein zweiter Zeitpuffer TY2>TY1 vorgegeben werden;
- TV1=T/2+D1 mit D1=DT+TY1 gilt;
- TV2=T/2+D2 mit D2=DT+TY2 gilt.

Vorzugsweise ist, insbesondere in Modus A, vorgesehen, dass
- vor dem Testen die Laststromstärke IL mit einem vorgegebenen unteren Schwellenwert verglichen wird;
- bei Überschreiten das Testen und andernfalls ein entsprechender Notplan ausgeführt und insbesondere das Testen nicht ausgeführt wird.

Das Vergleichen der Laststromstärke IL mit dem unteren Schwellenwert erfolgt bevorzugt vor Schaltschritt a oder b, in Modus A bevorzugt vor Schaltschritt a und in Modus b bevorzugt vor Schaltschritt a oder b.

Vorzugsweise ist, insbesondere in Modus A, vorgesehen, dass
- der Erfassungsschwellenwert höchstens ein vorgegebener Anteil der Nennstromstärke IN ist, und dieser Anteil bevorzugt 20% oder 15% oder 12% oder 11% oder 10% oder 7% oder 5% oder 2% oder 1% beträgt.

Vorzugsweise ist, insbesondere in Modus A, vorgesehen, dass der obere Schwellenwert
- von dem Erfassungsschwellenwert und/oder der Nennstromstärke IN und/oder der Kreisstromstärke IK abhängt; und/oder
- größer als der Erfassungsschwellenwert ist; und/oder
- größer oder gleich einem vorgegebenen Vielfachen des Erfassungsschwellenwerts ist, und dieses Vielfache 2 oder 2,5 oder 3 oder 3,5 oder 4 oder 4,5 oder 5 oder 6 oder 7 beträgt; und/oder
- kleiner oder gleich einem vorgegebenen Anteil der Kreisstromstärke IK ist, und dieser Anteil bevorzugt 90% oder 80% oder 70% oder 60% oder 55% oder 50% oder 45% oder 40% beträgt;
- kleiner oder gleich einem vorgegebenen maximalen Anteil der Nennstromstärke IN und/oder größer oder gleich einem vorgegebenen minimalen Anteil der Nennstromstärke IN ist, und der maximale Anteil bevorzugt 75% oder 70% oder 65% oder 60% oder 55% oder 50% oder 45% oder 40% oder 35% oder 30% und/oder der minimale Anteil bevorzugt 65% oder 60% oder 55% oder 50% oder 45% oder 40% oder 35% oder 30% oder 25% oder 20% beträgt.

Vorzugsweise ist, insbesondere in Modus A, vorgesehen, dass der untere Schwellenwert
- von dem Erfassungsschwellenwert und/oder der Nennstromstärke IN und/oder der Kreisstromstärke IK abhängt; und/oder
- größer oder gleich dem Erfassungsschwellenwert ist; und/oder
- höchstens um einen vorgegebenen Anteil größer als der Erfassungsschwellenwert ist, und dieser Anteil bevorzugt 5% oder 7% oder 10% oder 12% oder 15% oder 20% oder 25% oder 30% oder 35% oder 40% oder 45% oder 50% oder 60% oder 80% oder 100% oder 120% oder 150% oder 200% oder 250% oder 300% beträgt; und/oder
- kleiner als der obere Schwellenwert ist; und/oder
- kleiner oder gleich einem vorgegebenen Anteil der Kreisstromstärke IK ist, und dieser Anteil bevorzugt 60% oder 50% oder 40% oder 30% oder 25% oder 20% oder 17% oder 15% oder 12% oder 11% oder 10% oder 7% oder 5% beträgt;
- kleiner oder gleich einem vorgegebenen Anteil der Nennstromstärke IN ist, und dieser Anteil bevorzugt 20% oder 17% oder 15% oder 12% oder 11% oder 10% oder 7% oder 5% oder 2% oder 1% beträgt.

Vorzugsweise ist vorgesehen, dass
- bei einem negativen Testergebnis ein entsprechender Notplan ausgeführt wird und andernfalls das Umschalten gemäß dem Schaltablaufplan fortgesetzt wird; oder
- bei positivem Testergebnis das Umschalten gemäß dem Schaltablaufplan fortgesetzt wird und andernfalls ein entsprechender Notplan ausgeführt wird.

Falls wenigstens zwei Testergebnisse vorliegen, beispielsweise ein Testergebnis von dem Testen des Stroms i1 im ersten Hauptpfad und/oder ein Testergebnis von dem Testen des Stroms i2 im ersten Übergangspfad und/oder ein Testergebnis von dem Testen des Stroms i3 im zweiten Übergangspfad oder durch die erste oder zweite Anzapfung, dann wird bevorzugt der entsprechende Notplan ausgeführt, falls auch nur eines der Testergebnisse negativ sein sollte, und/oder wird das Umschalten gemäß dem Schaltablaufplan fortgesetzt, solange alle Testergebnisse positiv und/oder nicht negativ sind.

Vorzugsweise ist vorgesehen, dass gemäß dem Notplan
- die bisher gemäß dem Schaltablaufplan durchlaufenen Schaltschritte in umgekehrter Reihenfolge ausgeführt werden; und/oder
- die Anlage vom Wechselstromnetz getrennt wird; und/oder
- ein Warnsignal erzeugt wird, das dem jeweiligen negativen Testergebnis entspricht.

Die Erfindung schlägt gemäß einem dritten Aspekt eine Elektrische Anlage nach Anspruch 17 die zum Ausführen eines der vorgeschlagenen Verfahren ausgebildet ist, u.A. umfassend
- eine Regelwicklung, die an ein Wechselstromnetz mit einer vorgegebenen Periodendauer T gekoppelt ist, für eine vorgegebene Nennstromstärke IN ausgelegt ist und eine erste und eine zweite Anzapfung umfasst;
- einen Laststufenschalter, der an die Anzapfungen angeschlossen ist und umfasst
   - eine Lastableitung;
   - einen ersten Hauptpfad;
   - einen ersten Übergangspfad;
   - einen zweiten Übergangspfad;
   - einen zweiten Hauptpfad;
   - eine Trennschalteinrichtung, die derart ausgebildet ist, dass sie jeden Hauptpfad und jeden Übergangspfad trennen und verbinden kann;
   - eine Steuereinrichtung, die an die Trennschalteinrichtung gekoppelt ist.

Die Erfindung schlägt gemäß einem vierten Aspekt eine Elektrische nach Anspruch 18 vor, u.A.
- eine Regelwicklung, die an ein Wechselstromnetz mit einer vorgegebenen Periodendauer T gekoppelt ist, für eine vorgegebene Nennstromstärke IN ausgelegt ist und eine erste und eine zweite Anzapfung umfasst;
- einen Laststufenschalter, der an die Anzapfungen angeschlossen ist und umfasst
   - eine Lastableitung;
   - einen ersten Hauptpfad;
   - einen ersten Übergangspfad;
   - einen zweiten Übergangspfad;
   - einen zweiten Hauptpfad;
   - eine Trennschalteinrichtung, die derart ausgebildet ist, dass sie jeden Hauptpfad und jeden Übergangspfad trennen und verbinden kann;
   - eine Steuereinrichtung, die an die Trennschalteinrichtung gekoppelt ist; wobei
- der Laststufenschalter derart ausgebildet ist, dass er zum Ändern der aktiven Windungszahl der Regelwicklung
   - von einem ersten Dauerstromzustand, in dem ein Laststrom von der ersten Anzapfung über den ersten Hauptpfad zu der Lastableitung fließt und die zweite Anzapfung von der Lastableitung getrennt ist, gemäß einem vorgegebenen Schaltablaufplan zu einem zweiten Dauerstromzustand, in dem der Laststrom von der zweiten Anzapfung über den zweiten Hauptpfad zu der Lastableitung fließt und die erste Anzapfung von der Lastableitung getrennt ist, umschalten kann;
- der Schaltablaufplan vorschreibt, dass
   - ausgehend von dem ersten Dauerstromzustand in einem Schaltschritt a die erste Anzapfung über den ersten Übergangspfad mit der Lastableitung verbunden ist oder bleibt oder wird und der erste Hauptpfad getrennt wird;
   - nach Schaltschritt a in einem Schaltschritt b die zweite Anzapfung über den zweiten Übergangspfad mit der Lastableitung verbunden wird, sodass aufgrund der Stufenspannung zwischen der ersten und der zweiten Anzapfung ein Kreisstrom iK durch die Übergangspfade fließt;
   - nach Schaltschritt b in einem Schaltschritt c die erste Anzapfung von der Lastableitung getrennt wird;
   - nach Schaltschritt c in einem Schaltschritt d die zweite Anzapfung über den zweiten Hauptpfad mit der Lastableitung verbunden wird;
- die Steuereinrichtung derart ausgebildet ist, dass sie
   - zu wenigstens einem vorgegebenen Test-Zeitpunkt tT zwischen Schaltschritt a und Schaltschritt c testen kann, ob der erste Hauptpfad getrennt ist;
   - eine Stromstärke IL des Laststroms ermitteln kann;
   - den Test-Zeitpunkt tT in Abhängigkeit von der Laststromstärke IL bestimmen kann.

Diese Anlage ist zur Ausführung eines der vorgeschlagenen Verfahren ausgebildet. Jede dieser vorgeschlagenen Anlagen kann somit das ordnungsgemäße Trennen des ersten Hauptpfads überwachen.

Jede dieser vorgeschlagenen Anlagen ist bevorzugt symmetrisch ausgelegt, sodass sie beim Umschalten in der umgekehrten Richtung, also von dem zweiten zu dem ersten Dauerstromzustand, analog das ordnungsgemäße Trennen des zweiten Hauptpfads überwachen kann.

Das Ermitteln der Stromstärke erfolgt bevorzugt vor Schaltschritt a.

Vorzugsweise ist vorgesehen, dass
- die Steuereinrichtung einen Laststromsensor, der den Laststrom erfassen und ein entsprechendes Messsignal erzeugen kann, umfasst und derart ausgebildet ist, dass sie zum Ermitteln der Laststromstärke IL
   - dieses Messsignal verwendet.

Vorzugsweise ist vorgesehen, dass
- die Steuereinrichtung derart ausgebildet ist, dass sie
   - aus diesem Messsignal die Nulldurchgänge des Laststroms und/oder den ersten Nulldurchgang tN des Laststroms seit Beginn des Schaltschritts a und/oder den ersten Nulldurchgang tN des Laststroms seit Beginn des Schaltschritts b ermitteln kann.

Vorzugsweise ist vorgesehen, dass
- die Steuereinrichtung einen Stromsensor, der den Strom i1, der im ersten Hauptpfad fließt, erfassen und ein entsprechendes Messsignal erzeugen kann, umfasst und derart ausgebildet ist, dass sie zum Testen
   - dieses Messsignal mit einem vorgegebenen Erfassungsschwellenwert vergleicht;
   - bei Unterschreiten das Testergebnis als positiv und andernfalls als negativ wertet.

Vorzugsweise ist vorgesehen, dass
- die Steuereinrichtung einen Stromsensor, der den Strom i2, der im ersten Übergangspfad fließt, erfassen und ein entsprechendes Messsignal erzeugen kann, umfasst und derart ausgebildet ist, dass sie in Modus B zum Testen
   - dieses Messsignal mit einem vorgegebenen unteren Kreisstromschwellenwert vergleicht;
   - bei Überschreiten das Testergebnis als positiv und andernfalls als negativ wertet.

Vorzugsweise ist vorgesehen, dass
- die Steuereinrichtung einen Stromsensor, der den Strom i3, der im zweiten Übergangspfad oder durch die erste oder zweite Anzapfung fließt, erfassen und ein entsprechendes Messsignal erzeugen kann, umfasst und derart ausgebildet ist, dass sie in Modus B zum Testen
   - dieses Messsignal mit einem vorgegebenen oberen Kreisstromschwellenwert vergleicht;
   - bei Unterschreiten das Testergebnis als positiv und andernfalls als negativ wertet.

Die Erfindung schlägt abermals eine elektrische Anlage nach Anspruch 18 vor, umfassend
- eine Regelwicklung, die an ein Wechselstromnetz mit einer vorgegebenen Periodendauer T gekoppelt ist, für eine vorgegebene Nennstromstärke IN ausgelegt ist und eine erste und eine zweite Anzapfung umfasst;
- einen Laststufenschalter, der an die Anzapfungen angeschlossen ist und umfasst
   - eine Lastableitung;
   - einen ersten Hauptpfad;
   - einen ersten Übergangspfad;
   - einen zweiten Übergangspfad;
   - einen zweiten Hauptpfad;
   - eine Trennschalteinrichtung, die derart ausgebildet ist, dass sie jeden Hauptpfad und jeden Übergangspfad trennen und verbinden kann;
   - eine Steuereinrichtung, die an die Trennschalteinrichtung gekoppelt ist;
wobei
- der Laststufenschalter derart ausgebildet ist, dass er zum Ändern der aktiven Windungszahl der Regelwicklung
   - von einem ersten Dauerstromzustand, in dem ein Laststrom von der ersten Anzapfung über den ersten Hauptpfad zu der Lastableitung fließt und die zweite Anzapfung von der Lastableitung getrennt ist, gemäß einem vorgegebenen Schaltablaufplan zu einem zweiten Dauerstromzustand, in dem der Laststrom von der zweiten Anzapfung über den zweiten Hauptpfad zu der Lastableitung fließt und die erste Anzapfung von der Lastableitung getrennt ist, umschalten kann;
- der Schaltablaufplan vorschreibt, dass
   - ausgehend von dem ersten Dauerstromzustand in einem Schaltschritt a die erste Anzapfung über den ersten Übergangspfad mit der Lastableitung verbunden ist oder bleibt oder wird und der erste Hauptpfad getrennt wird;
   - nach Schaltschritt a in einem Schaltschritt b die zweite Anzapfung über den zweiten Übergangspfad mit der Lastableitung verbunden wird, sodass aufgrund der Stufenspannung zwischen der ersten und der zweiten Anzapfung ein Kreisstrom iK durch die Übergangspfade fließt;
   - nach Schaltschritt b in einem Schaltschritt c der erste Übergangspfad getrennt wird;
   - nach Schaltschritt c in einem Schaltschritt d die zweite Anzapfung über den zweiten Hauptpfad mit der Lastableitung verbunden wird;
- die Steuereinrichtung derart ausgebildet ist, dass sie
   - zu wenigstens einem vorgegebenen Test-Zeitpunkt tT zwischen Schaltschritt c und Schaltschritt d testen kann, ob der erste Übergangspfad getrennt ist;
   - eine Stromstärke IL des Laststroms ermitteln kann;
   - den Test-Zeitpunkt tT in Abhängigkeit von der Laststromstärke IL bestimmen kann.

Jede dieser vorgeschlagenen Anlagen ist bevorzugt symmetrisch ausgelegt, sodass sie beim Umschalten in der umgekehrten Richtung, also von dem zweiten zu dem ersten Dauerstromzustand, analog das ordnungsgemäße Trennen des zweiten Übergangspfads überwachen kann.

Das Trennen der ersten Anzapfung von der Lastableitung erfolgt bevorzugt entweder in Schaltschritt c oder zwischen Schaltschritt c und d.

Das Ermitteln der Stromstärke IL erfolgt bevorzugt vor Schaltschritt c.

Vorzugsweise ist vorgesehen, dass
- die Steuereinrichtung einen Stromsensor, der den Strom i2, der im ersten Übergangspfad fließt, erfassen und ein entsprechendes Messsignal erzeugen kann, umfasst und derart ausgebildet ist, dass sie zum Testen
   - dieses Messsignal mit einem vorgegebenen Erfassungsschwellenwert vergleicht;
   - bei Unterschreiten das Testergebnis als positiv und andernfalls als negativ wertet.

Vorzugsweise ist vorgesehen, dass
- die Trennschalteinrichtung umfasst
   - einen ersten Trennschalter, der in dem ersten Hauptpfad angeordnet ist;
   - einen zweiten Trennschalter, der in dem ersten Übergangspfad angeordnet ist;
   - einen dritten Trennschalter, der in dem zweiten Übergangspfad angeordnet ist;
   - einen vierten Trennschalter, der in dem zweiten Hauptpfad angeordnet ist.

Die Trennschalteinrichtung kann nach Bedarf auf beliebige Art und Weise ausgebildet sein und beispielsweise wenigstens einen oder keinen zusätzlichen Trennschalter umfassen.

Vorzugsweise ist vorgesehen, dass
- der Laststufenschalter für die Trennschalter einen Direktantrieb umfasst;
- die Steuereinrichtung an den Direktantrieb gekoppelt ist und derart ausgebildet ist, dass sie gemäß dem Notplan
   - den Direktantrieb derart ansteuern kann, dass die bisher gemäß dem Schaltablaufplan durchlaufenen Schaltschritte in umgekehrter Reihenfolge ausgeführt werden.

Vorzugsweise ist vorgesehen, dass
- der Direktantrieb für jeden Trennschalter einen eigenen, separaten Motor, der an den jeweiligen Trennschalter gekoppelt ist, umfasst; oder
- der Direktantrieb für jeweils wenigstens zwei Trennschalter ein gemeinsames Steuergetriebe, das an die jeweiligen Trennschalter gekoppelt ist, und einen gemeinsamen Motor, der an das jeweilige gemeinsame Steuergetriebe gekoppelt ist, umfasst.

Vorzugsweise ist vorgesehen, dass
- der Direktantrieb für jeden Trennschalter einen eigenen, separaten Motor, der an den jeweiligen Trennschalter gekoppelt ist, umfasst.

Vorzugsweise ist vorgesehen, dass
- jeder separate Motor derart an den jeweiligen Trennschalter gekoppelt ist, dass seine Bewegung direkt und/oder unmittelbar und/oder verzögerungsfrei eine Bewegung und/oder Betätigung dieses Trennschalters bewirkt.

Jede Kopplung zwischen einem separaten Motor und dem jeweiligen Trennschalter kann beispielhaft wenigstens eine Welle und/oder wenigstens ein Getriebe umfassen.

Vorzugsweise ist vorgesehen, dass
- der Direktantrieb für jeweils wenigstens zwei Trennschalter ein gemeinsames Steuergetriebe, das an die jeweiligen Trennschalter gekoppelt ist, und einen gemeinsamen Motor, der an das jeweilige gemeinsame Steuergetriebe gekoppelt ist, umfasst.

Vorzugsweise ist vorgesehen, dass
- jedes gemeinsame Steuergetriebe derart an die jeweiligen Trennschalter gekoppelt ist, dass seine Bewegung direkt und/oder unmittelbar und/oder verzögerungsfrei eine Bewegung und/oder Betätigung dieser Trennschalters bewirkt; und/oder
- jeder gemeinsame Motor derart an das jeweilige gemeinsame Steuergetriebe gekoppelt ist, dass seine Bewegung direkt und/oder unmittelbar und/oder verzögerungsfrei eine Bewegung dieses Steuergetriebes bewirkt.

Jede Kopplung zwischen einem gemeinsame Steuergetriebe und den jeweiligen Trennschaltern und jede Kopplung zwischen einem gemeinsamen Motor und dem jeweiligen gemeinsamen Steuergetriebe kann beispielhaft wenigstens eine Welle und/oder wenigstens ein Getriebe umfassen. Jedes gemeinsame Steuergetriebe umfasst üblicherweise eine Kurvenscheibe, die von dem jeweiligen gemeinsamen Motor angetrieben und deren Kurve von den jeweiligen Trennschaltern abgetastet wird, sodass diese in einer durch die Form der Kurve vorbestimmten zeitlichen Abfolge bewegt und/oder betätigt werden.

Ein Direktantrieb ermöglicht auf einfache Weise eine positive und negative Beschleunigung der Bewegung der zugeordneten Trennschalter und Steuergetriebe bis hin zur Richtungsumkehr.

Vorzugsweise ist vorgesehen, dass
- wenigstens einer der Trennschalter als Ölschalter oder als Vakuumschaltröhre ausgebildet ist.

Vorzugsweise ist vorgesehen, dass
- wenigstens einer der Stromsensoren einen Sättigungsstromwandler umfasst.

Bei jedem der vorgeschlagenen Verfahren und Anlagen erfolgt das Trennen eines Pfads und/oder das Öffnen eines Trennschalters bevorzugt galvanisch.

Vorzugsweise ist vorgesehen, dass
- die Anlage eine regelbare oder variable Kompensationsdrossel zum Liefern von induktiver Blindleistung in das Wechselstromnetz und/oder zum Kompensieren von kapazitiver Blindleistung aus dem Wechselstromnetz umfasst und die Regelwicklung zumindest einen Teil der Kompensationsdrossel bildet; und/oder
- die Anlage einen Regeltransformator mit einer Primärseite und einer Sekundärseite umfasst und die Regelwicklung zumindest einen Teil der Primärseite oder der Sekundärseite bildet.

Die Ausführungen und Erläuterungen zu einem der Aspekte der Erfindung, insbesondere zu einzelnen Merkmalen dieses Aspektes, gelten entsprechend auch analog für die anderen Aspekte der Erfindung.

Im Folgenden werden Ausführungsformen der Erfindung beispielhaft anhand der beigefügten Zeichnungen näher erläutert. Die daraus hervorgehenden einzelnen Merkmale sind jedoch nicht auf die einzelnen Ausführungsformen beschränkt, sondern können mit weiter oben beschriebenen einzelnen Merkmalen und/oder mit einzelnen Merkmalen anderer Ausführungsformen verbunden und/oder kombiniert werden. Die Einzelheiten in den Zeichnungen sind nur erläuternd, nicht aber beschränkend auszulegen. Die in den Ansprüchen enthaltenen Bezugszeichen sollen den Schutzbereich der Erfindung in keiner Weise beschränken, sondern verweisen lediglich auf die in den Zeichnungen gezeigten Ausführungsformen.

Die Zeichnungen zeigen in
- FIG. 1: eine erste Ausführungsform einer elektrischen Anlage mit einer ersten Ausführungsform eines Laststufenschalters in einem ersten Dauerstromzustand;
- FIG. 2: den Laststufenschalter aus FIG. 1 in einer ersten Übergangsphase nach einem Schaltschritt a;
- FIG. 3: den Laststufenschalter aus FIG. 1 in einer zweiten Übergangsphase nach einem Schaltschritt b;
- FIG. 4: den Laststufenschalter aus FIG. 1 in einer dritten Übergangsphase nach einem Schaltschritt c;
- FIG. 5: den Laststufenschalter aus FIG. 1 in einem zweiten Dauerstromzustand nach einem Schaltschritt d;
- FIG. 6: eine zweite Ausführungsform einer elektrischen Anlage mit einer zweiten Ausführungsform eines Laststufenschalters in einem ersten Dauerstromzustand;
- FIG. 7: ein Diagramm mit dem zeitlichen Verlauf des Stroms in einem ersten Hauptpfad einer ersten Phase bei großem Laststrom;
- FIG. 8: ein Diagramm ähnlich FIG. 7 für eine zweite Phase, die um 120° zu der ersten Phase verschoben ist;
- FIG. 9: ein Diagramm ähnlich FIG. 7 bei mittelgroßem Laststrom;
- FIG. 10: ein Diagramm ähnlich FIG. 9 für eine zweite Phase, die um 120° zu der ersten Phase verschoben ist;
- FIG. 11: ein Diagramm ähnlich FIG. 7 bei kleinem Laststrom;
- FIG. 12: ein Diagramm ähnlich FIG. 11 mit dem zeitlichen Verlauf des Stroms in einem ersten Übergangspfad;
- FIG. 13: ein Diagramm ähnlich FIG. 11 mit dem zeitlichen Verlauf des Stroms in einem zweiten Übergangspfad;
- FIG. 14: ein Diagramm ähnlich FIG. 7 mit dem zeitlichen Verlauf des Stroms in dem ersten Übergangspfad der ersten Phase.

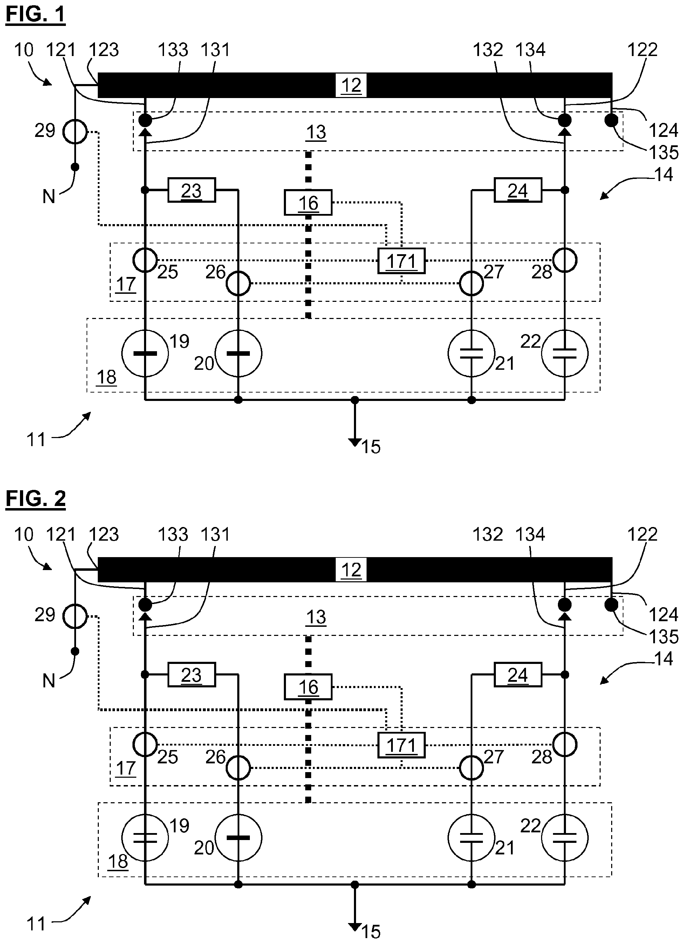

In FIG. 1 ist eine erste Ausführungsform einer an sich bekannten elektrischen Anlage 10 schematisch dargestellt, die beispielhaft eine regelbare Kompensationsdrossel zum Bereitstellen und/oder Liefern von Blindleistung in ein dreiphasiges Wechselstromnetz (nicht dargestellt) und zum Kompensieren von kapazitiver Blindleistung aus dem Wechselstromnetz bildet. Das Wechselstromnetz hat beispielhaft eine Netzfrequenz von 50 Hz und somit eine Periodendauer T=20 ms.

Die Anlage 10 umfasst in dieser Ausführungsform für jede Phase U, V, W des Wechselstromnetzes einen gemäß einer ersten Ausführungsform ausgebildeten Laststufenschalter 11 und eine Regelwicklung 12, wobei nur der für eine Phase U bestimmte Teil der Anlage 10 dargestellt ist. Die Regelwicklung 12 umfasst mehrere Anzapfungen, von denen nur eine erste 121 und eine zweite Anzapfung 122 dargestellt sind, sowie ein erstes Wicklungsende 123, das an eine Netzleitung N des Wechselstromnetzes angeschlossen ist, und ein zweites Wicklungsende 124 und ist für eine vorgegebene Nennstromstärke IN ausgelegt. Bei Bedarf kann zwischen erstes Wicklungsende 123 und Netzleitung N wenigstens eine Stammwicklung (nicht dargestellt) und/oder wenigstens eine zusätzliche Regelwicklung (nicht dargestellt) geschaltet sein. Das zweite Wicklungsende 124 ist beispielhaft als dritte Anzapfung ausgebildet, es kann aber auch nach Bedarf an einen Sternpunkt oder an einen Eckpunkt einer Dreieckschaltung angeschlossen sein.

Der Laststufenschalter 11 umfasst einen Wähler 13 mit zwei Bewegtkontakten 131, 132 und drei Festkontakten 133, 134, 135, einen Lastumschalter 14, der an den Wähler 13 angeschlossen ist, eine Lastableitung 15, die an den Lastumschalter 14 angeschlossen ist, einen Direktantrieb 16 für Wähler 13 und Lastumschalter 14 und eine gemäß einer ersten Ausführungsform ausgebildete Steuereinrichtung 17 mit einer Steuereinheit 171, die mit dem Direktantrieb 16 verbunden ist. Der erste Festkontakt 133 ist an die erste Anzapfung 121 angeschlossen, der zweite Festkontakt 134 an die zweite Anzapfung 122 und der dritte Festkontakt 135 an die dritte Anzapfung beziehungsweise das zweite Wicklungsende 124. Die Bewegtkontakte 131, 132 kontaktieren hier beispielhaft die erste 121 beziehungsweise zweite Anzapfung 122, jeder Bewegtkontakt 131, 132 kann aber auch mithilfe des Direktantriebs 16 wahlweise zu der dritten Anzapfung 124 oder einer der übrigen Anzapfungen bewegt werden und diese kontaktieren. Die Lastableitung 15 ist beispielhaft an Masse angeschlossen, sie kann aber auch nach Bedarf an Erdpotenzial oder an einen Sternpunkt oder an einen Eckpunkt einer Dreieckschaltung oder an eine Lastableitung (nicht dargestellt), die der Phase V der Anlage 10 zugeordnet ist, und/oder die Lastableitung (nicht dargestellt), die der Phase W der Anlage 10 zugeordnet ist, oder an eine Lastableitung (nicht dargestellt) eines zusätzlichen Laststufenschalters (nicht dargestellt), der der Phase U der Anlage 10 zugeordnet ist und an eine zusätzliche Regelwicklung (nicht dargestellt) angeschlossen ist, angeschlossen sein.

Bei dieser Ausführungsform des Laststufenschalters 11 umfasst der Lastumschalter 14 eine Trennschalteinrichtung 18 mit vier Trennschaltern oder Vakuumschaltröhren 19, 20, 21, 22, die durch den Direktantrieb 16 betätigt werden, und zwei Übergangswiderstände 23, 24. Die Vakuumschaltröhren 19...22 und die Übergangswiderstände 23, 24 sind symmetrisch auf zwei Zweige verteilt. Der erste Zweig umfasst eine Parallelschaltung aus der ersten Vakuumschaltröhre 19 und einer ersten Reihenschaltung aus dem ersten Übergangswiderstand 23 und der zweiten Vakuumschaltröhre 20, und der zweite Zweig umfasst eine Parallelschaltung aus der vierten Vakuumschaltröhre 22 und einer zweiten Reihenschaltung aus dem zweiten Übergangswiderstand 24 und der dritten Vakuumschaltröhre 21. Im ersten Zweig bildet die erste Vakuumschaltröhre 19 einen ersten Hauptpfad und die erste Reihenschaltung 20/23 einen ersten Übergangspfad. Im zweiten Zweig bildet die vierte Vakuumschaltröhre 22 einen zweiten Hauptpfad und die zweite Reihenschaltung 21/24 einen zweiten Übergangspfad.

Die Trennschalteinrichtung 18 ist derart ausgebildet, dass sie jeden Hauptpfad und jeden Übergangspfad mithilfe der durch den Direktantrieb 16 betätigten Vakuumschaltröhren 19...22 wahlweise trennen oder verbinden kann.

Der Laststufenschalter 11 derart ausgebildet ist, dass er zum Ändern der aktiven Windungszahl der Regelwicklung 12, also zum Ändern des von einem Laststrom iL durchflossenen Teils der Regelwicklung 12, von einem ersten Dauerstromzustand, in dem der Laststrom iL von der ersten Anzapfung 121 über den ersten Hauptpfad zu der Lastableitung 15 fließt und die zweite Anzapfung 122 von der Lastableitung 15 getrennt ist, gemäß einem vorgegebenen Schaltablaufplan zu einem zweiten Dauerstromzustand, in dem der Laststrom von der zweiten Anzapfung 122 über den zweiten Hauptpfad zu der Lastableitung 15 fließt und die erste Anzapfung 121 von der Lastableitung 15 getrennt ist, umschalten kann.

Die Steuereinrichtung 17 umfasst in dieser Ausführungsform für jeden Trennschalter einen Stromsensor 25, 26, 27, 28, von denen jeder als Sättigungsstromwandler ausgebildet ist, sowie einen Laststromsensor 29, der als Sättigungsstromwandler ausgebildet ist. Der erste Stromsensor 25 sitzt auf einer Leitung zum ersten Trennschalter 19 und kann den Strom i1, der im ersten Hauptpfad fließt, erfassen und ein entsprechendes erstes Messsignal erzeugen. Der zweite Stromsensor 26 sitzt auf einer Leitung zum zweiten Trennschalter 20 und kann den Strom i2, der im ersten Übergangspfad fließt, erfassen und ein entsprechendes zweites Messsignal erzeugen. Der dritte Stromsensor 27 sitzt auf einer Leitung zum dritten Trennschalter 21 und kann den Strom i3, der im zweiten Übergangspfad fließt, erfassen und ein entsprechendes drittes Messsignal erzeugen. Der vierte Stromsensor 28 sitzt auf einer Leitung zum vierten Trennschalter 22 und kann den Strom i4, der im zweiten Hauptpfad fließt, erfassen und ein entsprechendes viertes Messsignal erzeugen. Der Laststromsensor 29 sitzt auf der Leitung zwischen Wicklungsende 123 und Netzleitung N und kann den Laststrom iL, der durch die Regelwicklung 12 fließt, erfassen und ein entsprechendes fünftes Messsignal erzeugen.

FIG. 1 zeigt den Laststufenschalter 11 in einem ersten Dauerstromzustand, in dem ein Laststrom iL von der Netzleitung N zu der ersten Anzapfung 121 und von dort weiter über den ersten Hauptpfad zu der Lastableitung 15 fließt und die zweite Anzapfung 122 von der Lastableitung getrennt ist. Hierzu sind die erste Vakuumschaltröhre 19 geschlossen und die dritte und vierte Vakuumschaltröhre 21, 22 geöffnet. Bei dieser Ausführungsform des Laststufenschalter 11 ist zudem beispielhaft die erste Anzapfung 121 über den ersten Übergangspfad mit der Lastableitung 15 verbunden. Hierzu ist die zweite Vakuumschaltröhre 20 geschlossen. Es ist aber auch möglich, dass die zweite Vakuumschaltröhre 20 geöffnet ist, sodass die erste Anzapfung 121 nicht über den ersten Übergangspfad mit der Lastableitung 15 verbunden ist.

Der Laststufenschalter 11 ist derart ausgebildet, dass er zum Ändern der aktiven Windungszahl der Regelwicklung 12 von dem ersten Dauerstromzustand gemäß einem vorgegebenen Schaltablaufplan zu einem zweiten Dauerstromzustand umschalten kann. In dem zweiten Dauerstromzustand fließt der Laststrom iL von der Netzleitung N zu der zweiten Anzapfung 122 und von dort weiter über den zweiten Hauptpfad zu der Lastableitung 15 und ist die erste Anzapfung 121 von der Lastableitung getrennt. Hierzu sind die vierte Vakuumschaltröhre 22 geschlossen und die erste und zweite Vakuumschaltröhre 19, 20 geöffnet. Bei dieser Ausführungsform des Laststufenschalters 11 ist zudem beispielhaft die zweite Anzapfung 122 über den zweiten Übergangspfad mit der Lastableitung 15 verbunden. Hierzu ist die dritte Vakuumschaltröhre 21 geschlossen. Es ist aber auch möglich, dass die dritte Vakuumschaltröhre 21 ist, sodass die zweite Anzapfung 122 nicht über den zweiten Übergangspfad mit der Lastableitung 15 verbunden ist.

Nachfolgend wird dieser Schaltablaufplan beschrieben.

In FIG.2 ist der Laststufenschalter 11 in einer ersten Übergangsphase nach einem Schaltschritt a dargestellt. Der Schaltablaufplan schreibt vor, dass ausgehend von dem ersten Dauerstromzustand in diesem Schaltschritt die erste Anzapfung 121 über den ersten Übergangspfad mit der Lastableitung 15 verbunden bleibt - oder wird, falls er im ersten Dauerstromzustand getrennt war- und der erste Hauptpfad getrennt wird.

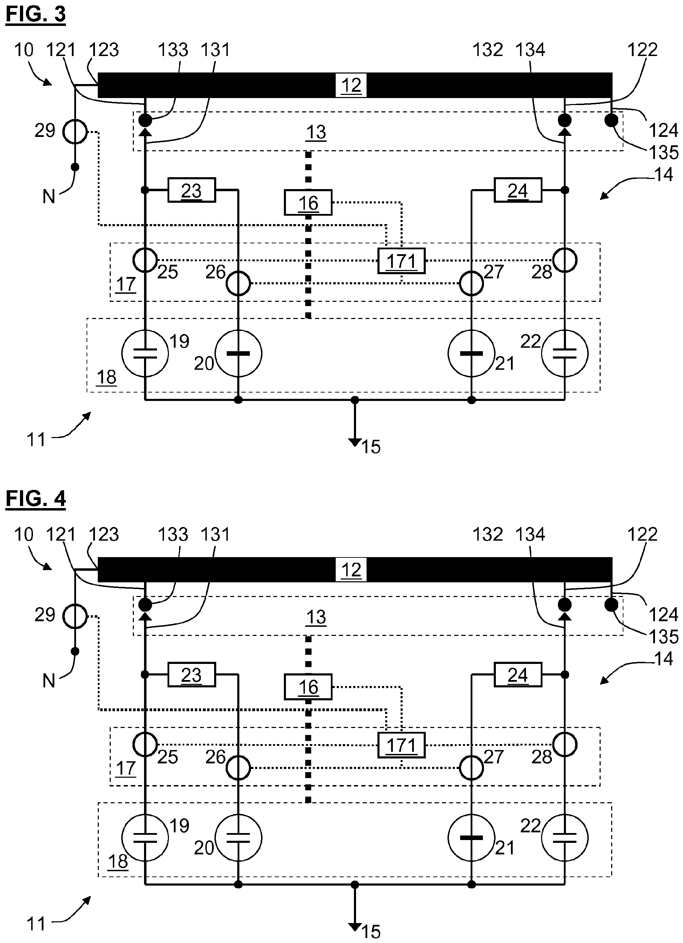

In FIG. 3 ist der Laststufenschalter 11 in einer zweiten Übergangsphase nach einem Schaltschritt b dargestellt. Der Schaltablaufplan schreibt vor, dass nach Schaltschritt a in diesem Schaltschritt die zweite Anzapfung 122 über den zweiten Übergangspfad mit der Lastableitung verbunden wird, sodass aufgrund der Stufenspannung zwischen der ersten und der zweiten Anzapfung 121, 122 ein Kreisstrom iK durch die Übergangspfade fließt.

In FIG. 4 ist der Laststufenschalter 11 in einer dritten Übergangsphase nach einem Schaltschritt c dargestellt. Der Schaltablaufplan schreibt vor, dass nach Schaltschritt b in diesem Schaltschritt die erste Anzapfung 121 von der Lastableitung getrennt wird.

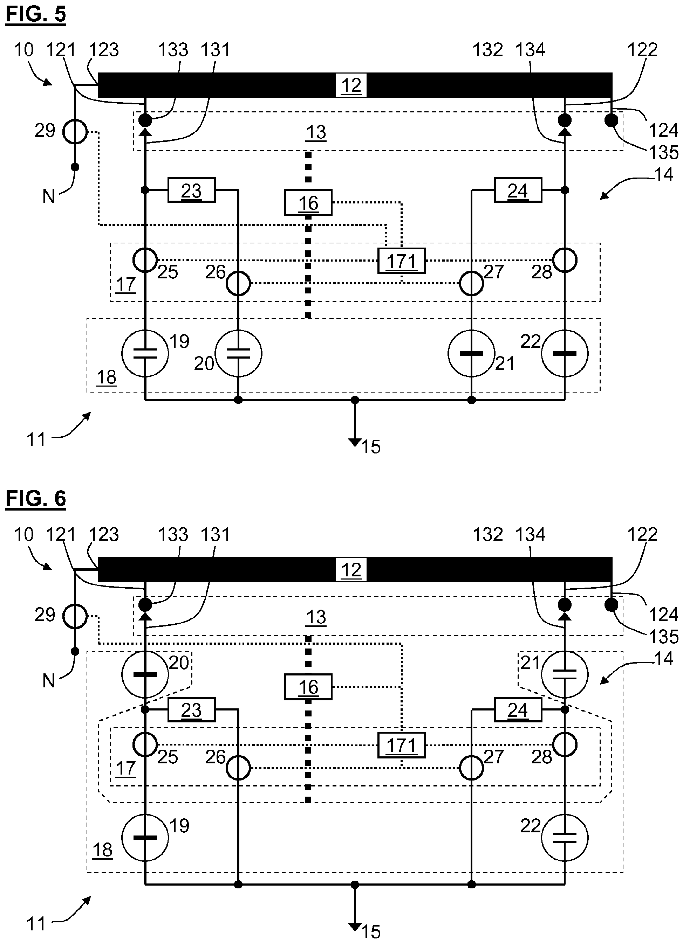

In FIG. 5 ist der Laststufenschalter 11 in dem zweiten Dauerstromzustand nach einem Schaltschritt d dargestellt. Der Schaltablaufplan schreibt vor, dass nach Schaltschritt d in diesem Schaltschritt die zweite Anzapfung 122 über den zweiten Hauptpfad mit der Lastableitung verbunden wird.

Die Steuereinrichtung 17 ist in dieser Ausführungsform derart ausgebildet ist, dass sie mithilfe der Steuereinheit 171
- einen Test-Zeitpunkt tT zwischen Schaltschritt a und Schaltschritt c vorgeben kann und zumindest zu diesem Test-Zeitpunkt tT testen kann, ob der erste Hauptpfad getrennt ist;
- eine Stromstärke IL des Laststroms iL ermitteln kann;
- diesen Test-Zeitpunkt tT in Abhängigkeit von der Laststromstärke IL bestimmen kann;
- zum Ermitteln der Laststromstärke IL
   - aus dem fünften Messsignal des Laststromsensors 29 beispielhaft den Effektivwert bildet;
- aus dem fünften Messsignal die Nulldurchgänge des Laststroms iL und den ersten Nulldurchgang tN des Laststroms iL seit Beginn ta des Schaltschritts a und den ersten Nulldurchgang tN des Laststroms iL seit Beginn tb des Schaltschritts b ermitteln kann;
- bei positivem Testergebnis das Umschalten gemäß dem Schaltablaufplan fortsetzt und andernfalls einen Notplan ausführt;
- gemäß dem Notplan
   - den Direktantrieb derart ansteuert, dass die bisher gemäß dem Schaltablaufplan durchlaufenen Schaltschritte in umgekehrter Reihenfolge ausgeführt werden;
- vor dem Testen die Laststromstärke IL mit einem vorgegebenen Modusschwellenwert SM vergleichen kann und bei Unterschreiten, also falls die Laststromstärke IL kleiner als der Modusschwellenwert SM ist, das Testen gemäß einem Modus B und andernfalls gemäß einem Modus A ausführt;
- eine Verzögerungszeit TV vorgibt und den Test-Zeitpunkt tT vor Schaltschritt b und um die Verzögerungszeit TV nach Beginn ta des Schaltschritts a legt;
- ein Test-Zeitintervall TT vorgeben kann, das von dem ersten Nulldurchgang tN des Laststroms seit Beginn ta des Schaltschritts a bis zu dem Test-Zeitpunkt tT reicht, und das Testen in dem Test-Zeitintervall TT ausführt.

Der Test-Zeitpunkt tT und die Verzögerungszeit TV hängen somit von dem ersten Nulldurchgang tN des Laststroms seit Beginn ta des Schaltschritts a ab.

Die Steuereinrichtung 17 ist in dieser Ausführungsform derart ausgebildet, dass sie mithilfe der Steuereinheit 171 in Modus A
- zum Testen
   - das erste Messsignal des ersten Stromsensors 25 mit einem vorgegebenen Erfassungsschwellenwert SE vergleicht und bei Unterschreiten, also falls dieses Messsignal kleiner als der Erfassungsschwellenwert SE ist, das Testergebnis als positiv und andernfalls als negativ wertet;
- vor dem Testen einen unteren Schwellenwert SU vorgibt, die Laststromstärke IL mit dem unteren Schwellenwert SU vergleicht und bei Überschreiten, also falls die Laststromstärke größer als der untere Schwellenwert SU ist, das Testen und andernfalls einen Notplan ausführt;
- einen oberen Schwellenwert SO vorgibt, die Laststromstärke IL mit dem oberen Schwellenwert SO vergleicht und bei Überschreiten, also falls die Laststromstärke größer als der obere Schwellenwert SO ist, die Verzögerungszeit tV auf einen vorgegebenen Wert TV1 und andernfalls auf einen vorgegebenen Wert TV2>TV1 setzt;
- einen ersten Zeitpuffer TY1 und einen zweiten Zeitpuffer TY2>TY1 vorgeben kann, wobei TV1=T/2+D1 mit D1=DT+TY1 und TV2=T/2+D2 mit D2=DT+TY2 gilt und DT die Trenndauer des Trennens ist.

Die Verzögerungszeit TV hängt somit von der Laststromstärke IL antiton ab.

TV1 und TV2 hängen somit von der Trenndauer DT proportional ab. Beispielhaft gilt: DT=1,5 ms, TY1=0 ms, TY2=2,5 ms, D1=1,5 ms, D2=4 ms, TV1=11,5ms, TV2=14ms.

Der Modusschwellenwert SM beträgt beispielhaft 30% der Nennstromstärke IN. Der Erfassungsschwellenwert SE beträgt beispielhaft 20% der Nennstromstärke IN. Der obere Schwellenwert SO beträgt beispielhaft 70% der Nennstromstärke IN. Der untere Schwellenwert SU beträgt beispielhaft 30% der Nennstromstärke IN und ist somit gleich dem Modusschwellenwert SM.

Die Steuereinrichtung 17 ist in dieser Ausführungsform derart ausgebildet, dass sie mithilfe der Steuereinheit 171 in Modus B
- zum Testen
   - einen unteren Kreisstromschwellenwert SKU vorgibt, das zweite Messsignal des zweiten Stromsensors 26 mit dem unteren Kreisstromschwellenwert SKU vergleicht und bei Überschreiten, also falls dieses Messsignal größer als der unteren Kreisstromschwellenwert SKU ist, das Testergebnis als positiv und andernfalls als negativ wertet;
   - einen oberen Kreisstromschwellenwert SKO vorgibt, das dritte Messsignal des dritten Stromsensors 27 mit dem oberen Kreisstromschwellenwert SKO vergleicht und bei Unterschreiten, also falls dieses Messsignal kleiner als der obere Kreisstromschwellenwert SKO ist, das Testergebnis als positiv und andernfalls als negativ wertet.
- eine Verzögerungszeit TV vorgibt und den Test-Zeitpunkt tT um die Verzögerungszeit TV nach Beginn tb des Schaltschritts b legt;

Der untere Kreisstromschwellenwert SKU beträgt beispielhaft 40% der Nennstromstärke IN. Der obere Kreisstromschwellenwert SKO beträgt beispielhaft 80% der Nennstromstärke IN und ist somit größer als der untere Kreisstromschwellenwert SKU.

Die Steuereinrichtung 17 ist in dieser Ausführungsform derart ausgebildet, dass sie mithilfe der Steuereinheit 171
- einen Test-Zeitpunkt tT zwischen Schaltschritt c und Schaltschritt d vorgeben kann und zumindest zu diesem Test-Zeitpunkt tT testen kann, ob der erste Übergangspfad getrennt ist;
- diesen Test-Zeitpunkt tT in Abhängigkeit von der Laststromstärke IL bestimmen kann;
- zum Testen
   - das zweite Messsignal des zweiten Stromsensors 26 mit dem Erfassungsschwellenwert SE vergleicht und bei Unterschreiten, also falls dieses Messsignal kleiner als der Erfassungsschwellenwert SE ist, das Testergebnis als positiv und andernfalls als negativ wertet;

In FIG. 6 ist eine zweite Ausführungsform der Anlage 10 schematisch dargestellt. Diese Ausführungsform ähnelt der ersten Ausführungsform, sodass im Folgenden vor Allem die Unterschiede näher erläutert werden.

Bei dieser Ausführungsform ist der Laststufenschalter 11 gemäß einer zweiten Ausführungsform ausgebildet, die der ersten Ausführungsform ähnelt, sodass im Folgenden vor Allem die Unterschiede näher erläutert werden.

Bei dieser Ausführungsform des Laststufenschalters 11 sind die erste und zweite Vakuumschaltröhre 19, 20 des ersten Zweigs und die dritte und vierte Vakuumschaltröhre 21, 22 des zweiten Zweigs jeweils in Reihe geschaltet. Der erste Übergangswiderstand 23 des ersten Zweigs ist zwischen zweite Vakuumschaltröhre 20 und ersten Stromsensor 25 geschaltet, der zweiten Übergangswiderstand 24 des zweiten Zweigs zwischen dritte Vakuumschaltröhre 21 und vierten Stromsensor 28.

Im ersten Zweig bilden die erste und zweite Vakuumschaltröhre 19, 20 den ersten Hauptpfad und die zweite Vakuumschaltröhre 20 und der erste Übergangswiderstand 23 den ersten Übergangspfad. Im zweiten Zweig bilden die dritte die vierte Vakuumschaltröhre 21, 22 den zweiten Hauptpfad und die dritte Vakuumschaltröhre 21 und der zweite Übergangswiderstand 24 den zweiten Übergangspfad.

Der in Zusammenhang mit der ersten Ausführungsform der Anlage 10 beschriebene Schaltablaufplan gilt analog auch für diese Ausführungsform der Anlage 10.

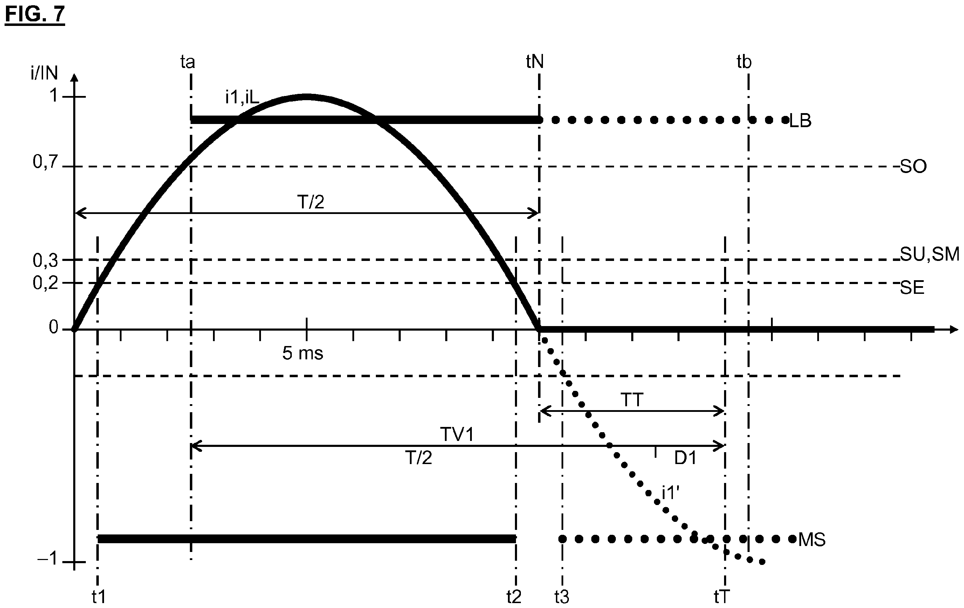

FIG. 7 ist ein Diagramm mit dem zeitlichen Verlauf des Stroms i1 durch die erste Vakuumschaltröhre 19 in dem ersten Hauptpfad der Phase U bei großem Laststrom iL mit SO<IL.

Da die Anlage 10 in der ersten und zweiten Ausführungsform eine regelbare oder variable Kompensationsdrossel zum Liefern von induktiver Blindleistung in das Wechselstromnetz und/oder zum Kompensieren von kapazitiver Blindleistung aus dem Wechselstromnetz bildet, umfasst die Steuereinrichtung 17 in dieser Ausführungsform beispielhaft einen Blindleistungsregler (nicht dargestellt), dessen Aufgabe es ist, die von der Kompensationsdrossel beziehungsweise Anlage 10 zu liefernde und/oder zu kompensierende Blindleistung einzustellen und/oder die Blindleistung des Wechselstromnetzes in einem vorbestimmten Blindleistungsband zu halten.

Falls der Blindleistungsregler beispielsweise erkennt, dass die Blindleistung des Wechselstromnetzes das Blindleistungsband verlässt, dann erzeugt die Steuereinrichtung 17 ein entsprechendes Schaltsignal zum Umschalten von dem ersten Dauerstromzustand, in dem sich die Anlage 10 beziehungsweise der Laststufenschalter 11 aktuell befindet, zu einem zweiten Dauerstromzustand, der geeignet ist, die Blindleistung des Wechselstromnetzes wieder zurück in das Blindleistungsband zu bringen. Nachdem die Steuereinrichtung 17 dieses Schaltsignal erzeugt hat, führt sie das weiter oben erläuterte erfindungsgemäße oder vorgeschlagene Verfahren zum Ändern der aktiven Windungszahl der Regelwicklung 12 aus.

Zunächst ermittelt die Steuereinrichtung 17 die Laststromstärke IL des Laststroms iL, vergleicht diese mit dem Modusschwellenwert SM vergleichen und führt bei Unterschreiten das Testen gemäß Modus B und andernfalls gemäß Modus A aus.

Da der Laststrom iL groß ist, gilt SO<IL und SM<SO und folglich SM≤IL, sodass die Steuereinrichtung 17 Modus A wählt.

Zum Zeitpunkt ta wird Schaltschritt a ausgeführt, zum Zeitpunkt tb Schaltschritt b, zum Test-Zeitpunkt tT das Testen. Ein Lichtbogen in der in Schaltschritt a geöffneten ersten Vakuumschaltröhre 19 stellt im Normalfall zunächst keinen Fehler dar und ist durch die Linie LB dargestellt, der Strom i1 fließt weiterhin im Wesentlichen unverändert durch den ersten Hauptpfad. Das erste Messsignal des ersten Stromsensors 25 ist durch die Linie MS dargestellt, zum Zeitpunkt t1 überschreitet der Strom i1 den Erfassungsschwellenwert SE und zum Zeitpunkt t2 unterschreitet der Strom i1 den Erfassungsschwellenwert SE, sodass dieses Messsignal MS vor t1 AUS ist, zwischen t1 und t2 EIN ist, und nach t2 wieder AUS ist. Im Normalfall erlischt der Lichtbogen LB beim ersten Nulldurchgang tN seit ta, sodass dieses Messsignal MS ab tN weiterhin AUS ist. Im Fehlerfall, falls also die erste Vakuumschaltröhre 19 nicht ordnungsgemäß geöffnet hat, erlischt der Lichtbogen LB beim Nulldurchgang tN nicht, dargestellt durch die punktierte Linie LB, sodass der Strom i1 weiterhin fließt, dargestellt durch die punktierte Linie i1', und dieses Messsignal MS EIN ist, dargestellt durch die punktierte Linie MS.

Für den Strom i1 gilt zwischen ta und tN im Normalfall i1=iL und ab tN im Normalfall i1=0, dargestellt durch die dicke durchgezogene Linie i1, und ab tN im Fehlerfall i1'=iL, dargestellt durch die dicke punktierte Linie i1'.

Gemäß Modus A testet die Steuereinrichtung 17 innerhalb des Zeitintervalls TT, ob der Strom i1 den Erfassungsschwellenwert SE unterschreitet. Hierfür testet sie, ob das erste Messsignal MS AUS oder EIN ist, und sie erkennt frühestens zum Zeitpunkt t3 und spätestens zum Zeitpunkt tt, ob dieses Messsignal MS während des Zeitintervalls TT entsprechend dem Normalfall ständig AUS oder entsprechend dem Fehlerfall wenigstens einmal EIN war.

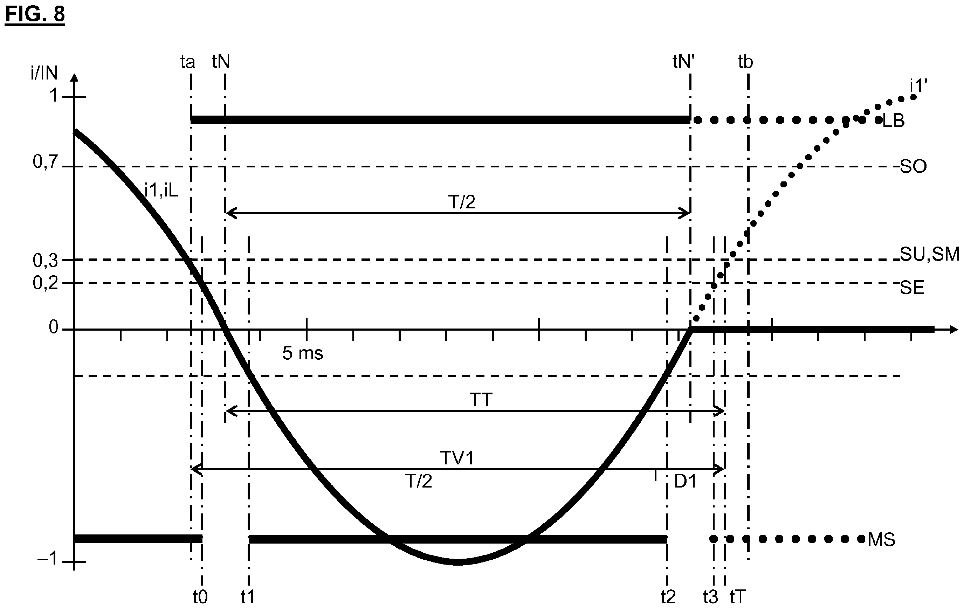

FIG. 8 ist ein Diagramm entsprechend FIG. 7 mit dem zeitlichen Verlauf des Stroms i1 durch die erste Vakuumschaltröhre 19 in dem ersten Hauptpfad der Phase V, die um 120° zu der Phase U verschoben ist, bei großem Laststrom IL.

Zum Überwachen der ersten Vakuumschaltröhre 19 wählt die Steuereinrichtung 17 den Test-Zeitpunkt tT derart, dass er eine vorgegebene Verzögerungszeit TV=TV1 nach Beginn ta des Schaltschritts a liegt. Dabei wird berücksichtigt, dass auch in Phase V, in der der Lichtbogen LB im Normalfall bei ordnungsgemäßem Öffnen der entsprechenden ersten Vakuumschaltröhre später als in Phase U erlöschen wird, genügend Zeit für die Auswertung des entsprechenden ersten Messsignals bleibt.

Da ta so kurz vor tN liegt, dass die erste Vakuumschaltröhre 19 bei TN noch nicht vollständig geöffnet ist, kann der Lichtbogen LB auch im Normallfall nicht zum Zeitpunkt tN erlöschen, sondern erst beim nächsten Nulldurchgang zum Zeitpunkt tN'.

Für den Strom i1 gilt zwischen ta und tN' im Normalfall i1=iL und ab tN' im Normalfall i1=0, dargestellt durch die dicke durchgezogene Linie i1, und ab tN' im Fehlerfall i1'=iL, dargestellt durch die dicke punktierte Linie i1'.

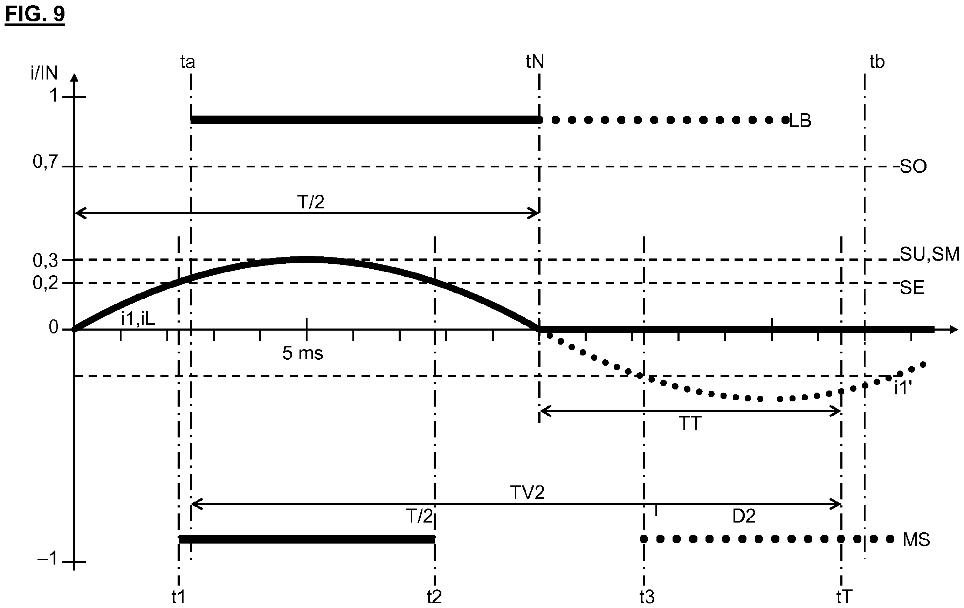

FIG. 9 ist ein Diagramm entsprechend FIG. 7 mit dem zeitlichen Verlauf des Stroms i1 der Phase U bei mittelgroßem Laststrom iL mit SU≤IL≤SO.

Da der Laststrom iL mittelgroß ist, gilt SU≤iL≤SO und SM=SU und folglich SM≤IL, sodass die Steuereinrichtung 17 Modus A wählt.

Da dieser mittelgroße Laststrom iL kleiner als der große Laststrom iL der FIG. 7 und 8 ist, ist das Zeitintervall zwischen t1 und t2 größer als das entsprechende Zeitintervall bei dem großen Laststrom iL. aus der Länge dieses Zeitintervall kann daher die Laststromstärke IL ermittelt werden.

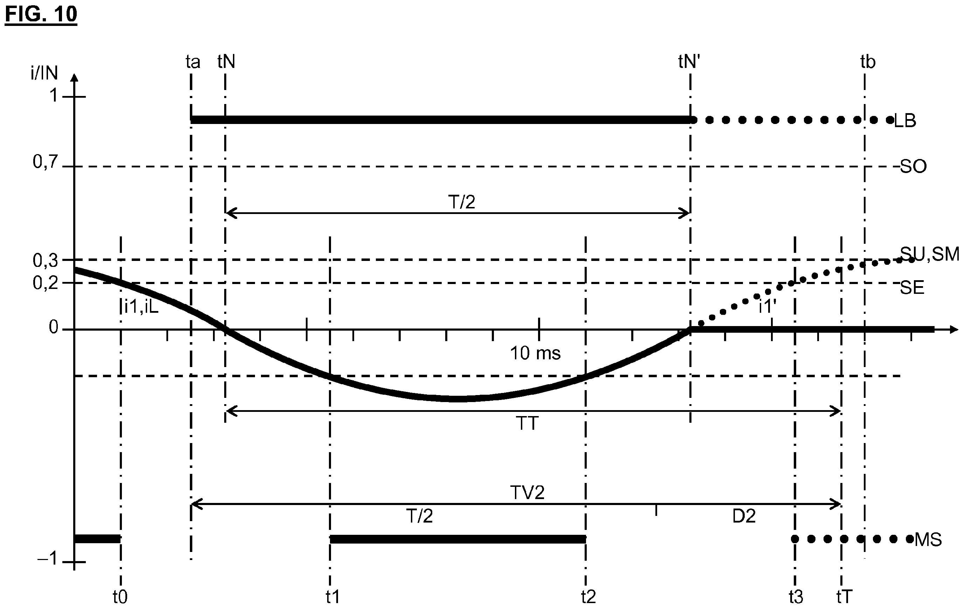

FIG. 10 ist ein Diagramm entsprechend FIG. 9 mit dem zeitlichen Verlauf des Stroms i1 der Phase V bei mittelgroßem Laststrom iL.

Bei diesem mittelgroßen Laststrom gibt die Steuereinrichtung 17 die Verzögerungszeit TV=TV2 vor, die größer als bei dem großem Laststrom ist. Hierzu steuert sie beispielhaft den Direktantrieb 16 derart an, dass seine Geschwindigkeit im Vergleich zu dem großem Laststrom verringert wird.

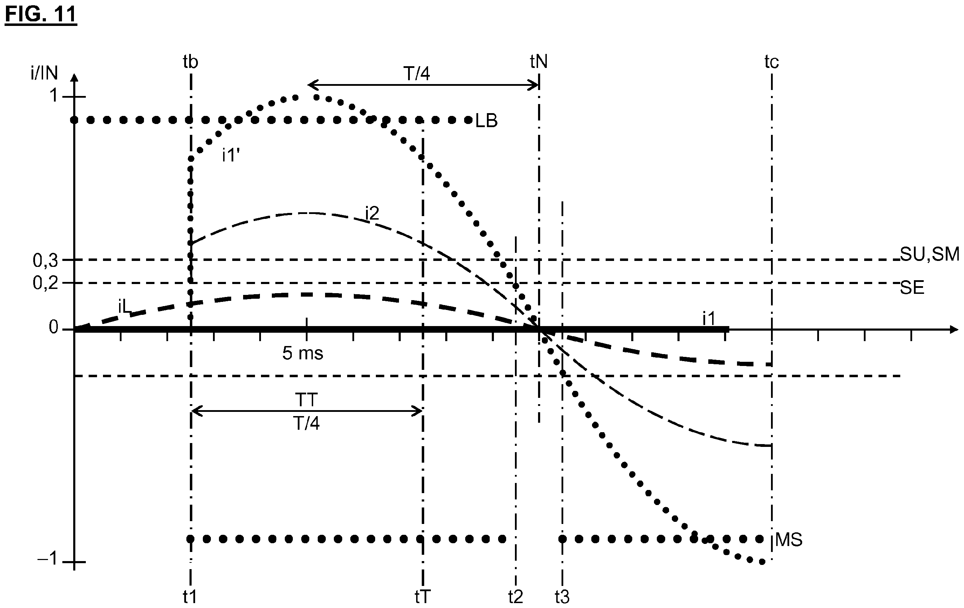

FIG. 11 ist ein Diagramm entsprechend FIG. 7 mit dem zeitlichen Verlauf des Stroms i1 der Phase U und mit dem zeitlichen Verlauf des Stroms i2 durch die zweite Vakuumschaltröhre 20 in dem ersten Übergangspfad der Phase U bei kleinem Laststrom iL mit IL<SU=SM.

Da der Laststrom iL klein ist, gilt iL<SU und SM=SU und folglich IL<SM, sodass die Steuereinrichtung 17 Modus B wählt.

Bei diesem kleinen Laststrom iL ist das Testen gemäß Modus A nicht wie bei dem großen und mittelgroßen Laststrom iL gemäß Fig. 7 bis 10 möglich, da der Laststrom iL nie den Erfassungsschwellenwert SE sicher und zuverlässig erfassbar übersteigt. Folglich ist sowohl im Normalfall als auch in dem Fehlerfall das erste Messsignal MS bis zum Zeitpunkt t1 AUS.

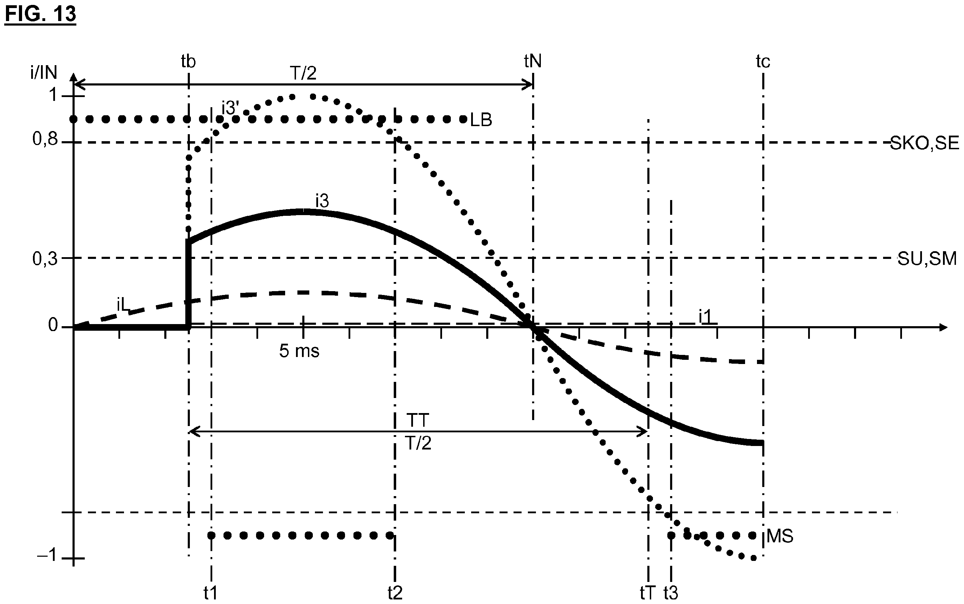

Zum Zeitpunkt tb fließt im Normallfall bei ordnungsgemäßem Öffnen der ersten Vakuumschaltröhre 19 in Schaltschritt a und bei ordnungsgemäßem Schließen der zweiten Vakuumschaltröhre 20 in Schaltschritt b ein Kreisstrom iK durch den ersten Festkontakt 133, den ersten Übergangspfad mit der zweiten Vakuumschaltröhre 20, den zweiten Übergangspfad mit der dritten Vakuumschaltröhre 21 und den zweiten Festkontakt 134, fließt zusätzlich der Laststrom iL durch den ersten Festkontakt 133, den ersten Übergangspfad mit der zweiten Vakuumschaltröhre 20 und die Lastableitung 15, und fließt lein Strom durch den ersten Hauptpfad mit der ersten Vakuumschaltröhre 19, vgl. FIG. 3. Folglich gilt für den Strom i2 durch den ersten Übergangspfad i2=iK+iL, dargestellt durch die dünne gestrichelte Linie, gilt für den Strom i3, der durch den zweiten Übergangspfad und die dritte Vakuumschaltröhre 21 fließt, i3=iK (FIG. 13), und gilt für den Strom i1 durch den ersten Hauptpfad i1=0.

Im Fehlerfall, wenn also die erste Vakuumschaltröhre 19 in Schaltschritt a nicht ordnungsgemäß geöffnet hat, erlischt der Lichtbogen LB beim Nulldurchgang tN nicht, sodass der erste Übergangspfad mit dem ersten Übergangswiderstand 23 durch den ersten Hauptpfad, der nahezu widerstandslos ist, überbrückt wird und der Kreisstrom iK nun mit doppelter Stromstärke als im Normalfall durch den ersten Hauptpfad und den zweiten Übergangspfad mit dem zweiten Übergangswiderstand 24 fließt. Auch der Laststrom iL fließt nun deutlich stärker als im Normalfall durch den ersten Hauptpfad, sodass für den Strom i1' durch den ersten Hauptpfad im Fehlerfall, dargestellt durch die punktierte Linie i1', annähernd i1'=2xi2 gilt und für den Strom i3' durch den zweiten Übergangspfad im Fehlerfall (in FIG. 13 dargestellt durch die punktierte Linie i3'), i3'=2xiK gilt. Da der Laststrom iL klein ist mit IL<SU, kann er den Kreisstrom iK auch im ungünstigsten Fall nicht so stark kompensieren, dass im Fehlerfall i1'<SU oder gar i1'<SE gilt. Dieser Strom i1' ist demnach so stark, dass er den Erfassungsschwellenwert SE sicher und zuverlässig erfassbar übersteigt, sodass dieses Messsignal MS, dargestellt durch die punktierte Linie MS, zwischen t1 und t2, also vor dem ersten Nulldurchgang tN seit tb, und ab t3, also nach tN, EIN ist.

Für den Strom i1 gilt ab tb im Normalfall i1=0, dargestellt durch die dicke durchgezogene Linie i1, und im Fehlerfall annähernd i1'=2xi2, dargestellt durch die dicke punktierte Linie i1'.

Gemäß Modus B testet die Steuereinrichtung 17 gemäß einer ersten Variante zwischen Schaltschritten b und c innerhalb des Zeitintervalls TT, das zum Zeitpunkt tb beginnt, ob der Strom i1 den Erfassungsschwellenwert SE unterschreitet. Hierfür testet sie, ob das erste Messsignal MS AUS oder EIN ist, und sie erkennt im Fehlerfall frühestens zum Zeitpunkt t1 und spätestens zum Zeitpunkt tt, ob dieses Messsignal MS während des Zeitintervalls TT entsprechend dem Normalfall ständig AUS oder entsprechend dem Fehlerfall wenigstens einmal EIN war.

Die Steuereinrichtung 17 hat dabei für das Zeitintervall TT den Wert TT=T/4 gewählt.

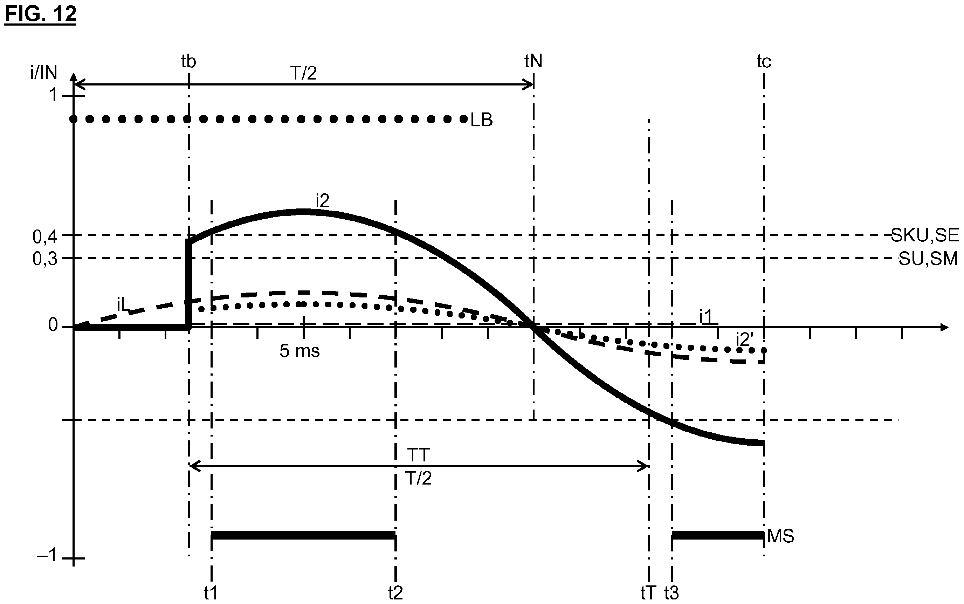

FIG. 12 ist ein Diagramm entsprechend FIG. 11 mit dem zeitlichen Verlauf des Stroms i2 der Phase U bei kleinem Laststrom iL.

Für den Strom i2 gilt zwischen tb und tc im Normalfall i2=iK, dargestellt durch die dicke durchgezogene Linie i2, und im Fehlerfall annähernd i2'<iL, dargestellt durch die dicke punktierte Linie i2'.

Gemäß Modus B testet die Steuereinrichtung 17 gemäß einer zweiten Variante zwischen Schaltschritten b und c innerhalb des Zeitintervalls TT, das zum Zeitpunkt tb beginnt, ob der Strom i2 den unteren Kreisstromschwellenwert SKU überschreitet. Hierfür testet sie, ob das zweite Messsignal MS des zweiten Stromsensors 26 EIN oder AUS ist, und sie erkennt frühestens zum Zeitpunkt t1 und spätestens zum Zeitpunkt tt, ob dieses Messsignal MS während des Zeitintervalls TT entsprechend dem Normalfall wenigstens einmal EIN oder entsprechend dem Fehlerfall ständig AUS war.

Die Steuereinrichtung 17 hat dabei für das Zeitintervall TT den Wert TT=T/2 gewählt und für den Erfassungsschwellenwert SE des zweiten Stromsensors 26 den Wert SE=SKU.

FIG. 13 ist ein Diagramm entsprechend FIG. 12 mit dem zeitlichen Verlauf des Stroms i3 der Phase U bei kleinem Laststrom iL.

Für den Strom i3 gilt zwischen tb und tc im Normalfall i3=iK, dargestellt durch die dicke durchgezogene Linie i3, und im Fehlerfall i3'=2xiK, dargestellt durch die dicke punktierte Linie i3'.

Gemäß Modus B testet die Steuereinrichtung 17 gemäß einer dritten Variante zwischen Schaltschritten b und c innerhalb des Zeitintervalls TT, das zum Zeitpunkt tb beginnt, ob der Strom i3 den oberen Kreisstromschwellenwert SKO unterschreitet. Hierfür testet sie, ob das dritte Messsignal MS des dritten Stromsensors 27 AUS oder EIN ist, und sie erkennt frühestens zum Zeitpunkt t1 und spätestens zum Zeitpunkt tt, ob dieses Messsignal MS während des Zeitintervalls TT entsprechend dem Normalfall ständig AUS oder entsprechend dem Fehlerfall wenigstens einmal EIN war.

Die Steuereinrichtung 17 hat dabei für das Zeitintervall TT den Wert TT=T/2 gewählt und für den Erfassungsschwellenwert SE des dritten Stromsensors 27 den Wert SE=SKO.

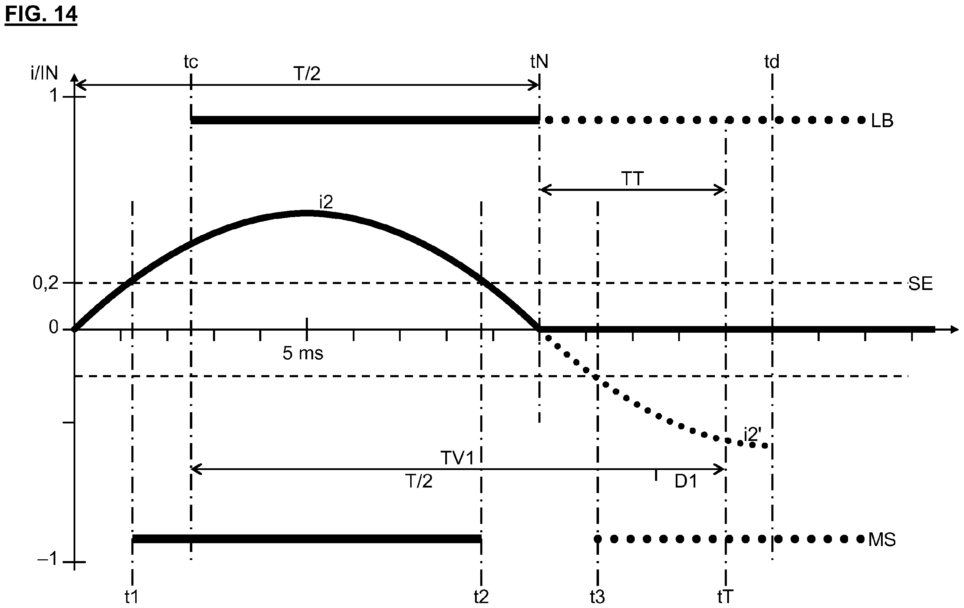

FIG. 14 ist ein Diagramm entsprechend FIG. 7 mit dem zeitlichen Verlauf des Stroms i2 der Phase U bei großem Laststrom iL.

Zum Überwachen der zweiten Vakuumschaltröhre 20 wählt die Steuereinrichtung 17 den Test-Zeitpunkt tT derart, dass er eine vorgegebene Verzögerungszeit TV=TV1 nach Beginn tc des Schaltschritts c liegt. Dabei wird berücksichtigt, dass auch in Phase V, in der der Lichtbogen LB bei ordnungsgemäßem Öffnen der entsprechenden zweiten Vakuumschaltröhre 20 erst später als in Phase U erlöschen wird, genügend Zeit für die Auswertung des zweiten Messsignals bleibt.

Für den Strom i2 gilt zwischen ta und tN im Normalfall i2=iK+iL und ab tN im Normalfall i2=0, dargestellt durch die dicke durchgezogene Linie i2, und ab tN im Fehlerfall i2'=iK+iL, dargestellt durch die dicke punktierte Linie i2'.

Die Steuereinrichtung 17 testet innerhalb des Zeitintervalls TT, ob der Strom i2 den Erfassungsschwellenwert SE unterschreitet. Hierfür testet sie, ob das zweite Messsignal MS AUS oder EIN ist, und sie erkennt frühestens zum Zeitpunkt t3 und spätestens zum Zeitpunkt tt, ob dieses Messsignal MS während des Zeitintervalls TT entsprechend dem Normalfall ständig AUS oder entsprechend dem Fehlerfall wenigstens einmal EIN war.

### BEZUGSZEICHEN

- 10: elektrische Anlage
- 11: Laststufenschalter
- 12: Regelwicklung
- 121/122: erste/zweite Anzapfung von 12
- 123: erstes Wicklungsende von 12
- 124: zweites Wicklungsende von 12, dritte Anzapfung von 12
- 13: Wähler
- 131/132: erster/zweiter Bewegtkontakt von 13
- 133/134/135: erster/zweiter/dritter Festkontakt von 13
- 14: Lastumschalter
- 15: Lastableitung
- 16: Direktantrieb
- 17: Steuereinrichtung
- 171: Steuereinheit von 17
- 18: Trennschalteinrichtung
- 19: erste Vakuumschaltröhre
- 20: zweite Vakuumschaltröhre
- 21: dritte Vakuumschaltröhre
- 22: vierte Vakuumschaltröhre
- 23: erste Übergangswiderstand
- 24: zweiten Übergangswiderstand
- 25: erster Stromsensor
- 26: zweiter Stromsensor
- 27: dritter Stromsensor
- 28: vierter Stromsensor
- 29: Laststromsensor
- N: Netzleitung des Wechselstromnetzes
- U, V, W: Phasen des Wechselstromnetzes

## Patentansprüche

1. Verfahren zum Ändern der aktiven Windungszahl einer Regelwicklung (12) in einer elektrischen Anlage (10), wobei
- die Regelwicklung (12) an ein Wechselstromnetz mit einer vorgegebenen Periodendauer T gekoppelt ist, für eine vorgegebene Nennstromstärke IN ausgelegt ist und eine erste und eine zweite Anzapfung (121, 122) umfasst;
- von einem ersten Dauerstromzustand, in dem ein Laststrom (iL) von der ersten Anzapfung (121) über einen ersten Hauptpfad zu einer Lastableitung (15) fließt und die zweite Anzapfung (122) von der Lastableitung (15) getrennt ist, gemäß einem vorgegebenen Schaltablaufplan zu einem zweiten Dauerstromzustand, in dem der Laststrom von der zweiten Anzapfung (122) über einen zweiten Hauptpfad zu der Lastableitung (15) fließt und die erste Anzapfung (121) von der Lastableitung (15) getrennt ist, umgeschaltet wird;
- der Schaltablaufplan vorschreibt, dass
• ausgehend von dem ersten Dauerstromzustand in einem Schaltschritt a die erste Anzapfung (121) über einen ersten Übergangspfad mit der Lastableitung (15) verbunden ist oder bleibt oder wird und der erste Hauptpfad getrennt wird;
• nach Schaltschritt a in einem Schaltschritt b die zweite Anzapfung (122) über einen zweiten Übergangspfad mit der Lastableitung (15) verbunden wird, sodass aufgrund der Stufenspannung zwischen den Anzapfungen (121, 122) ein Kreisstrom iK durch die Übergangspfade fließt;
• nach Schaltschritt b in einem Schaltschritt c die erste Anzapfung (121) von der Lastableitung (15) getrennt wird;
• nach Schaltschritt c in einem Schaltschritt d die zweite Anzapfung (122) über den zweiten Hauptpfad mit der Lastableitung (15) verbunden wird;
- zu wenigstens einem vorgegebenen Test-Zeitpunkt tT zwischen Schaltschritt a und Schaltschritt c getestet wird, ob der erste Hauptpfad getrennt ist;
- eine Stromstärke IL des Laststroms ermittelt wird;
- der Test-Zeitpunkt tT von der Laststromstärke IL abhängt.

2. Verfahren nach dem vorigen Anspruch, wobei
- das Testen umfasst, dass
• der Strom i1, der im ersten Hauptpfad fließt, erfasst wird und mit einem vorgegebenen Erfassungsschwellenwert (SE) verglichen wird;
• bei Unterschreiten das Testergebnis als positiv und andernfalls als negativ gewertet wird.

3. Verfahren nach einem der vorigen Ansprüche, wobei
- der Test-Zeitpunkt tT eine vorgegebene Verzögerungszeit TV nach Beginn (ta) des Schaltschritts a liegt und/oderder Test-Zeitpunkt tT vor Schaltschritt b liegt.

4. Verfahren nach einem der vorigen Ansprüche, wobei
- vor dem Testen die Laststromstärke IL mit einem vorgegebenen Modusschwellenwert (SM) verglichen wird;
- bei Überschreiten das Testen gemäß einem Modus A und andernfalls gemäß einem Modus B ausgeführt wird.

5. Verfahren nach dem vorigen Anspruch , wobei in Modus B
- der Test-Zeitpunkt tT nach Schaltschritt b liegt;
- das Testen umfasst, dass
• der Strom i2, der im ersten Übergangspfad fließt, erfasst wird und mit einem vorgegebenen unteren Kreisstromschwellenwert (SKU) verglichen wird;
• bei Überschreiten das Testergebnis als positiv und andernfalls als negativ gewertet wird;

6. Verfahren nach Anspruch 5, wobei
- das Testen umfasst, dass
• der Strom i3, der im zweiten Übergangspfad oder durch die erste oder zweite Anzapfung fließt, erfasst wird und mit einem vorgegebenen oberen Kreisstromschwellenwert (SKO) verglichen wird;
• bei Unterschreiten das Testergebnis als positiv und andernfalls als negativ gewertet wird.

7. Verfahren nach einem der Ansprüche Anspruch 5 bis 6, wobei
- der Test-Zeitpunkt tT eine vorgegebene Verzögerungszeit TV nach Beginn (tb) des Schaltschritts b liegt.

8. Verfahren nach einem der vorigen Ansprüche, wobei
- das Testen in einem Test-Zeitintervall TT erfolgt, das von dem ersten Nulldurchgang tN des Laststroms seit Beginn (ta) des Schaltschritts a bis zu dem Test-Zeitpunkt tT reicht; und/oder
- das Testen nach oder ab dem ersten Nulldurchgang tN des Laststroms seit Beginn (ta) des Schaltschritts a und bis zu dem Test-Zeitpunkt tT erfolgt.

9. Verfahrenzum Ändern der aktiven Windungszahl einer Regelwicklung in einer elektrischen Anlage (10), wobei
- die Regelwicklung (12) an ein Wechselstromnetz mit einer vorgegebenen Periodendauer T gekoppelt ist, für eine vorgegebene Nennstromstärke IN ausgelegt ist und eine erste und eine zweite Anzapfung (121, 122) umfasst;
- von einem ersten Dauerstromzustand, in dem ein Laststrom (iL) von der ersten Anzapfung (121) über einen ersten Hauptpfad zu einer Lastableitung (15) fließt und die zweite Anzapfung (122) von der Lastableitung (15) getrennt ist, gemäß einem vorgegebenen Schaltablaufplan zu einem zweiten Dauerstromzustand, in dem der Laststrom von der zweiten Anzapfung (122) über einen zweiten Hauptpfad zu der Lastableitung (15) fließt und die erste Anzapfung (121) von der Lastableitung (15) getrennt ist, umgeschaltet wird;
- der Schaltablaufplan vorschreibt, dass
• ausgehend von dem ersten Dauerstromzustand in einem Schaltschritt a die erste Anzapfung (121) über einen ersten Übergangspfad mit der Lastableitung (15) verbunden ist oder bleibt oder wird und der erste Hauptpfad getrennt wird;
• nach Schaltschritt a in einem Schaltschritt b die zweite Anzapfung (122) über einen zweiten Übergangspfad mit der Lastableitung (15) verbunden wird, sodass aufgrund der Stufenspannung zwischen den Anzapfungen (121, 122) ein Kreisstrom iK durch die Übergangspfade fließt;
• nach Schaltschritt b in einem Schaltschritt c der erste Übergangspfad getrennt wird;
• nach Schaltschritt c in einem Schaltschritt d die zweite Anzapfung (122) über den zweiten Hauptpfad mit der Lastableitung (15) verbunden wird;
- zu wenigstens einem vorgegebenen Test-Zeitpunkt tT zwischen Schaltschritt c und Schaltschritt d getestet wird, ob der erste Übergangspfad getrennt ist;
- eine Stromstärke IL des Laststroms ermittelt wird;
- der Test-Zeitpunkt tT von der Laststromstärke IL abhängt.

10. Verfahren nach dem vorigen Anspruch, wobei
- das Testen umfasst, dass
• der Strom i2, der im ersten Übergangspfad fließt, erfasst wird und mit einem vorgegebenen Erfassungsschwellenwert (SE) verglichen wird;
• bei Unterschreiten das Testergebnis als positiv und andernfalls als negativ gewertet wird.

11. Verfahren nach einem der Ansprüche 9 bis10, wobei
- der Test-Zeitpunkt tT eine vorgegebene Verzögerungszeit TV nach Beginn (tc) des Schaltschritts c liegt; und/oder
- der Test-Zeitpunkt tT vor Schaltschritt d liegt.

12. Verfahren nach einem der vorigen Ansprüche 9 bis 11, wobei
- das Testen in einem Test-Zeitintervall TT erfolgt, das von dem ersten Nulldurchgang tN des Laststroms seit Beginn (tc) des Schaltschritts c bis zu dem Test-Zeitpunkt tT reicht; und/oder
- das Testen nach oder ab dem ersten Nulldurchgang tN des Laststroms seit Beginn (tc) des Schaltschritts c und bis zu dem Test-Zeitpunkt tT erfolgt.

13. Verfahren nach einem der vorigen Ansprüche, wobei
- der Schaltablaufplan vorschreibt, dass
• in Schaltschritt a der erste Hauptpfad getrennt wird, indem ein erster Trennschalter in dem ersten Hauptpfad geöffnet wird; und/oder
• in Schaltschritt c die erste Anzapfung von der Lastableitung getrennt wird, indem der erste Übergangspfad getrennt wird, insbesondere indem ein zweiter Trennschalter in dem ersten Übergangspfad geöffnet wird; und/oder
• durch/nach Schaltschritt d der zweite Dauerstromzustand erreicht wird;
- das Testen des ersten Hauptpfads dadurch erfolgt, dass das Öffnen des ersten Trennschalters getestet wird; und/oder
- das Testen des ersten Übergangspfads dadurch erfolgt, dass das Öffnen des zweiten Trennschalters getestet wird; und/oder
- wenigstens einer der Trennschalter als Ölschalter oder als Vakuumschaltröhre ausgebildet ist; und/oder
- wenigstens einer der Trennschalter mithilfe eines Direktantriebs betätigt wird.

14. Verfahren nach einem der vorigen Ansprüche, wobei
- die Laststromstärke IL mit einem vorgegebenen oberen Schwellenwert (SO) verglichen wird;
- bei Überschreiten die Verzögerungszeit tV auf einen vorgegebenen Wert TV1 und andernfalls auf einen vorgegebenen Wert TV2>TV1 gesetzt wird.

15. Verfahren nach einem der vorigen Ansprüche, wobei
- vor dem Testen die Laststromstärke IL mit einem vorgegebenen unteren Schwellenwert (SU) verglichen wird;
- bei Überschreiten das Testen und andernfalls ein entsprechender Notplan ausgeführt wird.

16. Verfahren nach einem der vorigen Ansprüche, wobei
- bei positivem Testergebnis das Umschalten gemäß dem Schaltablaufplan fortgesetzt wird und andernfalls ein entsprechender Notplan ausgeführt wird;
- gemäß dem Notplan
• die bisher gemäß dem Schaltablaufplan durchlaufenen Schaltschritte in umgekehrter Reihenfolge ausgeführt werden; und/oder
• die Anlage (10) vom Wechselstromnetz getrennt wird; und/oder
• ein Warnsignal erzeugt wird, das dem jeweiligen negativen Testergebnis entspricht.

17. Elektrische Anlage (10), umfassend
- eine Regelwicklung (12), die an ein Wechselstromnetz mit einer vorgegebenen Periodendauer T gekoppelt ist, für eine vorgegebene Nennstromstärke IN ausgelegt ist und eine erste und eine zweite Anzapfung (121, 122) umfasst;
- einen Laststufenschalter (11), der an die Anzapfungen (121, 122) angeschlossen ist und umfasst
• eine Lastableitung (15);
• einen ersten Hauptpfad;
• einen ersten Übergangspfad;
• einen zweiten Übergangspfad;
• einen zweiten Hauptpfad;
• eine Trennschalteinrichtung (18), die derart ausgebildet ist, dass sie jeden Hauptpfad und jeden Übergangspfad trennen und verbinden kann;
• eine Steuereinrichtung (17), die an die Trennschalteinrichtung (18) gekoppelt ist; **dadurch gekennzeichnet, dass**
- der Laststufenschalter (11) derart ausgebildet ist, dass er zum Ändern der aktiven Windungszahl der Regelwicklung (12)
• von einem ersten Dauerstromzustand, in dem ein Laststrom (iL) von der ersten Anzapfung (121) über den ersten Hauptpfad zu der Lastableitung (15) fließt und die zweite Anzapfung (122) von der Lastableitung (15) getrennt ist, gemäß einem vorgegebenen Schaltablaufplan zu einem zweiten Dauerstromzustand, in dem der Laststrom von der zweiten Anzapfung (122) über den zweiten Hauptpfad zu der Lastableitung (15) fließt und die erste Anzapfung (121) von der Lastableitung (15) getrennt ist, umschalten kann;
- der Schaltablaufplan vorschreibt, dass
• ausgehend von dem ersten Dauerstromzustand in einem Schaltschritt a die erste Anzapfung (121) über den ersten Übergangspfad mit der Lastableitung (15) verbunden ist oder bleibt oder wird und der erste Hauptpfad getrennt wird;
• nach Schaltschritt a in einem Schaltschritt b die zweite Anzapfung (122) über den zweiten Übergangspfad mit der Lastableitung (15) verbunden wird, sodass aufgrund der Stufenspannung zwischen den Anzapfungen (121, 122) ein Kreisstrom (iK) durch die Übergangspfade fließt;
• nach Schaltschritt b in einem Schaltschritt c die erste Anzapfung (121) von der Lastableitung (15) getrennt wird;
• nach Schaltschritt c in einem Schaltschritt d die zweite Anzapfung (122) über den zweiten Hauptpfad mit der Lastableitung (15) verbunden wird;
- die Steuereinrichtung (17) derart ausgebildet ist, dass sie
• zu wenigstens einem vorgegebenen Test-Zeitpunkt tT zwischen Schaltschritt a und Schaltschritt c testen kann, ob der erste Hauptpfad getrennt ist;
• eine Stromstärke IL des Laststroms ermitteln kann;
• den Test-Zeitpunkt tT in Abhängigkeit von der Laststromstärke IL bestimmen kann.

18. Elektrische Anlage (10), , umfassend
- eine Regelwicklung (12), die an ein Wechselstromnetz mit einer vorgegebenen Periodendauer T gekoppelt ist, für eine vorgegebene Nennstromstärke IN ausgelegt ist und eine erste und eine zweite Anzapfung (121, 122) umfasst;
- einen Laststufenschalter (11), der an die Anzapfungen (121, 122) angeschlossen ist und umfasst
• eine Lastableitung (15);
• einen ersten Hauptpfad;
• einen ersten Übergangspfad;
• einen zweiten Übergangspfad;
• einen zweiten Hauptpfad;
• eine Trennschalteinrichtung (18), die derart ausgebildet ist, dass sie jeden Hauptpfad und jeden Übergangspfad trennen und verbinden kann;
• eine Steuereinrichtung (17), die an die Trennschalteinrichtung (18) gekoppelt ist; **dadurch gekennzeichnet, dass**
- der Laststufenschalter (11) derart ausgebildet ist, dass er zum Ändern der aktiven Windungszahl der Regelwicklung (12)
• von einem ersten Dauerstromzustand, in dem ein Laststrom (iL) von der ersten Anzapfung (121) über den ersten Hauptpfad zu der Lastableitung (15) fließt und die zweite Anzapfung (122) von der Lastableitung (15) getrennt ist, gemäß einem vorgegebenen Schaltablaufplan zu einem zweiten Dauerstromzustand, in dem der Laststrom (iL) von der zweiten Anzapfung (122) über den zweiten Hauptpfad zu der Lastableitung (15) fließt und die erste Anzapfung (121) von der Lastableitung (15) getrennt ist, umschalten kann;
- der Schaltablaufplan vorschreibt, dass
• ausgehend von dem ersten Dauerstromzustand in einem Schaltschritt a die erste Anzapfung (121) über den ersten Übergangspfad mit der Lastableitung (15) verbunden ist oder bleibt oder wird und der erste Hauptpfad getrennt wird;
• nach Schaltschritt a in einem Schaltschritt b die zweite Anzapfung (122) über den zweiten Übergangspfad mit der Lastableitung (15) verbunden wird, sodass aufgrund der Stufenspannung zwischen der ersten und der zweiten Anzapfung (121, 122) ein Kreisstrom (iK) durch die Übergangspfade fließt;
• nach Schaltschritt b in einem Schaltschritt c der erste Übergangspfad getrennt wird;
• nach Schaltschritt c in einem Schaltschritt d die zweite Anzapfung (122) über den zweiten Hauptpfad mit der Lastableitung (15) verbunden wird;
- die Steuereinrichtung (17) derart ausgebildet ist, dass sie
• zu wenigstens einem vorgegebenen Test-Zeitpunkt tT zwischen Schaltschritt c und Schaltschritt d testen kann, ob der erste Übergangspfad getrennt ist;
• eine Stromstärke IL des Laststroms ermitteln kann;
• den Test-Zeitpunkt tT in Abhängigkeit von der Laststromstärke IL bestimmen kann.

19. Verfahren oder Anlage (10) nach einem der vorigen Ansprüche, wobei
- die Anlage (10) eine regelbare oder variable Kompensationsdrossel zum Liefern von induktiver Blindleistung in das Wechselstromnetz und/oder zum Kompensieren von kapazitiver Blindleistung aus dem Wechselstromnetz umfasst und die Regelwicklung (12) zumindest einen Teil der Kompensationsdrossel bildet; und/oder
- die Anlage (10) einen Regeltransformator mit einer Primärseite und einer Sekundärseite umfasst und die Regelwicklung (12) zumindest einen Teil der Primärseite oder der Sekundärseite bildet.

## Claims

1. Method of changing the active winding number of a regulating winding (12) in an electrical installation (10), wherein
- the regulating winding (12) is coupled to an alternating current mains with a predetermined period duration T, is designed for a predetermined nominal current strength IN and comprises a first and a second tap (121, 122);
- switching over takes place in accordance with a predetermined switching sequence plan from a first continuous current state, in which a load current (iL) flows from the first tap (121) to a load output line (15) by way of a first main path and the second tap (122) is separated from the load output line (15), to a second continuous current state, in which the load current flows from the second tap (122) to the load output line (15) by way of a second main path and the first tap (121) is separated from the load output line (15);
- the switching sequence plan prescribes that
- starting from the first continuous current state in a switching step a the first tap (121) is or remains connected with the load output line (15) by way of a first transition path and the first main path is isolated;
- in a switching step b after switching step a the second tap (122) is connected with the load output line (15) by way of a second transition path so that a circular current iK flows through the transition paths due to the step voltage between the taps (121, 122);
- in a switching step c after switching step b the first tap (121) is separated from the load output line (15); and
- in a switching step d after switching step c the second tap (122) is connected with the load output line (15) by way of the second main path;
- at at least one predetermined test instant tT between switching step a and switching step c it is tested whether the first main path is isolated;
- a current strength IL of the load current is determined; and
- the test instant tT depends on the load current strength IL.

2. Method according to the preceding claim, wherein
- the testing comprises
- detecting the current i1 flowing in the first main path and comparing it with a predetermined detection threshold value (SE); and
- evaluating the test result as positive if the threshold value is fallen below and otherwise evaluating it as negative.

3. Method according to one of the preceding claims, wherein
- the test instant tT lies at a predetermined delay time TV after the start (ta) of the switching step a and/or the test instant tT lies ahead of the switching step b.

4. Method according to any one of the preceding claims, wherein
- prior to the testing the load current strength IL is compared with a predetermined mode threshold value (SM); and
- the testing is carried out in accordance with a mode A if the threshold value is fallen below and otherwise is carried out in accordance with a mode B.

5. Method according to the preceding claim, wherein in mode B
- the test instant tT lies after switching step b; and
- the testing comprises
- detecting the current i2 flowing in the first transition path and comparing it with a predetermined lower circular current threshold value (SKU); and
- evaluating the test result as positive if the threshold value is fallen below and otherwise evaluating it as negative.

6. Method according to claim 5, wherein
- the testing comprises
- detecting the current i3 flowing in the second transition path or through the first or second tap and comparing it with a predetermined upper circular current threshold value (SKO);
- evaluating the test result as positive if the threshold value is fallen below and otherwise evaluating it as negative.

7. Method according to one of claims 5 and 6, wherein
- the test instant tT lies at a predetermined delay time TV after the start (tb) of the switching step b.

8. Method according to any one of the preceding claims, wherein
- the testing is carried out at a test time interval TT extending from the first zero transition tN of the load current since the start (ta) of the switching step a to the test instant tT; and/or
- the testing is carried out after or from the first zero transition tN of the load current since the start (ta) of the switching step a and up to the test instant tT.

9. Method for changing the active winding number of a regulating winding in an electrical installation (10), wherein
- the regulating winding (12) is coupled to an alternating current mains with a predetermined period duration T, is designed for a predetermined nominal current strength IN and comprises a first and a second tap (121, 122);
- switching over takes place in accordance with a predetermined switching sequence plan from a first continuous current state, in which a load current (iL) flows from the first tap (121) to a load output line (15) by way of a first main path and the second tap (122) is separated from the load output line (15), to a second continuous current state, in which the load current flows from the second tap (122) to the load output line (15) by way of a second main path and the first tap (121) is separated from the load output line (15);
- the switching sequence plan prescribes that
- starting from the first continuous current state in a switching step a the first tap (121) is or remains connected with the load output line (15) by way of a first transition path and the first main path is isolated;
- in a switching step b after switching step a the second tap (122) is connected with the load output line (15) by way of a second transition path so that a circular current iK flows through the transition paths due to the step voltage between the taps (121, 122);
- in a switching step c after switching step b the first transition path is separated; and
- in a switching step d after switching step c the second tap (122) is connected with the load output line (15) by way of the second main path;
- at at least one predetermined test instant tT between switching step c and switching step d it is tested whether the first transition path is isolated;
- a current strength IL of the load current is determined; and
- the test instant tT depends on the load current strength IL.

10. Method according to the preceding claim, wherein
- the testing comprises
- detecting the current i2 flowing in the first transition path and comparing it with a predetermined detection threshold value (SE); and
- evaluating the test result as positive if the threshold value is fallen below and otherwise evaluating it as negative.

11. Method according to one of claims 9 and 10, wherein
- the test instant tT lies at a predetermined delay time TV after the start (tc) of the switching step c; and/or
- the test instant tT lies in front of the switching step d.

12. Method according to any one of the preceding claims 9 to 11, wherein
- the testing is carried out at a test time interval TT extending from the first zero transition tN of the load current since the start (tc) of the switching step c to the test instant tT; and/or
- the testing is carried out after or from the first zero transition tN of the load current since the start (tc) of the switching step c and up to the test instant tT.

13. Method according to any one of the preceding claims, wherein
- the switching sequence plan prescribes that
- in switching step a the first main path is isolated in that a first isolating switch in the first main path is opened; and/or
- in switching step c the first tap is isolated from the load output line in that the first transition path is isolated, particularly in that a second isolating switch in the first transition path is opened; and/or
- through/after switching step d the second continuous current state is reached;
- the testing of the first main path is carried out in that the opening of the first isolating switch is tested; and/or
- the testing of the first transition path is carried out in that the opening of the second isolating switch is tested; and/or
- at least one of the isolating switches is formed as an oil switch or as a vacuum interrupter; and/or
- at least one of the isolating switches is actuated with the help of a direct drive.

14. Method according to any one of the preceding claims, wherein
- the load current strength IL is compared with a predetermined upper threshold value (SO); and
- if the threshold value is exceeded the delay time tV is set to a predetermined value TV1 and otherwise to a predetermined value TV2 > TV1.

15. Method according to any one of the preceding claims, wherein
- prior to the testing the load current strength IL is compared with a predetermined lower threshold value (SU); and
- if the threshold value is exceeded the testing is performed and otherwise an appropriate emergency plan is executed.

16. Method according to any one of the preceding claims, wherein
- in the case of a positive test result the switching over is continued in accordance with the switching sequence plan and otherwise an appropriate emergency plan is executed; and
- in accordance with the emergency plan
- the switching steps previously run through in accordance with the switching sequence plan are executed in reverse sequence; and/or
- the installation (10) is separated from the alternating current mains; and/or
- a warning signal corresponding with the respective negative test result is generated.

17. Electrical installation (10), comprising
- a regulating winding (12) which is coupled to an alternating current mains with a predetermined period duration T, is designed for a predetermined nominal current strength IN and comprises a first and a second tap (121, 122);
- an on-load tap changer (11) connected with the taps (121, 122) and comprising
- a load output line (15);
- a first main path;
- a first transition path;
- a second transition path;
- a second main path;
- an isolating switching device (18) so constructed that it can isolate and connect each main path and each transition path; and
- a control device (17) coupled to the isolating switching device (18);
**characterised in that**
- the on-load tap changer (11) is so constructed that for changing the active winding number of the regulating winding (12) it can switch over in accordance with the predetermined switching sequence plan
- from a first continuous current state, in which a load current (iL) flows from the first tap (121) to the load output line (15) by way of the first main path and the second tap (122) is separated from the load output line (15), to a second continuous current state, in which the load current flows from the second tap (122) to the load output line (15) by way of the second main path and the first tap (121) is separated from the load output line (15);
- the switching sequence plan prescribes that
- starting from a first continuous current state in a switching step a the first tap (121) is or remains connected with the load output line (15) by way of a first transition path and the first main path is isolated;
- in a switching step b after switching step a the second tap (122) is connected with the load output line (15) by way of the second transition path so that a circular current iK flows through the transition paths due to the step voltage between the taps (121, 122);
- in a switching step c after switching step b the first tap (121) is separated from the load output line (15); and
- in a switching step d after switching step c the second tap (122) is connected with the load output line (15) by way of the second main path;
- the control device (17) is so constructed that it
- can test at at least one predetermined test instant tT between switching step a and switching step c whether the first main path is isolated;
- can detect a current strength IL of the load current; and
- can determine the test instant tT in dependence on the load current strength.

18. Electrical installation (10), comprising
- a regulating winding (12) which is coupled to an alternating current mains with a predetermined period duration T, is designed for a predetermined nominal current strength IN and comprises a first and a second tap (121, 122);
- an on-load tap changer (11) connected with the taps (121, 122) and comprising
- a load output line (15);
- a first main path;
- a first transition path;
- a second transition path;
- a second main path;
- an isolating switching device (18) so constructed that it can isolate and connect each main path and each transition path; and
- a control device (17) coupled to the isolating switching device (18);
**characterised in that**
- the on-load tap changer (11) is so constructed that for changing the active winding number of the regulating winding (12) it can switch over in accordance with the predetermined switching sequence plan
- from a first continuous current state, in which a load current (iL) flows from the first tap (121) to the load output line (15) by way of the first main path and the second tap (122) is separated from the load output line (15), to a second continuous current state, in which the load current flows from the second tap (122) to the load output line (15) by way of the second main path and the first tap (121) is separated from the load output line (15);
- the switching sequence plan prescribes that
- starting from a first continuous current state in a switching step a the first tap (121) is or remains connected with the load output line (15) by way of the first transition path and the first main path is isolated;
- in a switching step b after switching step a the second tap (122) is connected with the load output line (15) by way of the second transition path so that a circular current iK flows through the transition paths due to the step voltage between the first and second taps (121, 122);
- in a switching step c after switching step b the first transition path is isolated; and
- in a switching step d after switching step c the second tap (122) is connected with the load output line (15) by way of the second main path;
- the control device (17) is so constructed that it
- can test at at least one predetermined test instant tT between switching step c and switching step d whether the first main path is isolated;
- can determine a current strength IL of the load current; and
- can determine the test time instant tT in dependence on the load current strength.

19. Method according to one of the preceding method claims or installation (10) according to any one of the preceding installation claims, wherein
- the installation (10) comprises a regulable or variable compensation choke for supplying inductive reactive current to the alternating current mains and/or for compensating for capacitive reactive current from the alternating current mains and the regulating winding (12) forms at least a part of the compensation choke; and/or
- the installation (10) comprises a regulating transformer with a primary side and a secondary side and the regulating winding (12) forms at least a part of the primary side or the secondary side.

## Revendications

1. Procédé permettant de modifier le nombre d'enroulements actifs d'un enroulement de réglage (12) dans une installation électrique (10) selon lequel :
- l'enroulement de réglage (12) est couplé à un réseau de courant alternatif ayant une période T prédéfinie, est conçu pour une intensité de courant nominale IN prédéfinie, et comporte une première prise et une seconde prise (121, 122),
- on effectue une commutation conformément à un programme de commutation prédéfini entre un premier état de courant continu dans lequel un courant de charge (iL) circule de la première prise (121) vers une dérivation de charge (15) par un premier chemin principal et la seconde prise (122) est séparée de la dérivation de charge (15), et un second état de courant continu dans lequel le courant de charge circule de la seconde prise (122) vers la dérivation de charge (15) par un second chemin principal et la première prise (121) est séparée de la dérivation de charge (15), et
- le programme de commutation prescrit que :
• à partir du premier état de courant continu, dans une étape de commutation a, la première prise (121) est ou reste reliée par un premier chemin de transfert avec la dérivation de charge (15), et le premier chemin principal est séparé,
• après l'étape de commutation a, dans une étape de commutation b la seconde prise (122) est reliée par un second chemin de transfert avec la dérivation de charge (15) de sorte que, en raison du gradin de tension entre les prises (121, 122) un courant circulaire iK circule dans les chemins de transfert,
• après l'étape de commutation b, dans une étape de commutation c la première prise (121) est séparée de la dérivation de charge (15),
• après l'étape de commutation c, dans une étape de commutation d la seconde prise (122) est reliée par le second chemin principal avec la dérivation de charge (15),
- à au moins un instant de test prédéfini tT entre l'étape de commutation a et l'étape de commutation c on vérifie si le premier chemin principal est séparé,
- on détermine l'intensité iL du courant de charge,
- l'instant de test prédéfini tT dépend de l'intensité du courant de charge iL.

2. Procédé conforme à la revendication précédente,
selon lequel :
- lors du test :
• le courant il qui circule dans le premier chemin principal est détecté, et comparé avec une valeur de seuil de détection prédéfinie (SE),
• en cas de passage au dessous de cette valeur le résultat du test est considéré comme positif et sinon il est considéré comme négatif.

3. Procédé conforme à l'une quelconque des revendications précédentes selon lequel :
- l'instant de test tT est situé avec une durée de temporisation TV prédéfinie après le début (ta) de l'étape de commutation a et/ou l'instant de test tT est situé avant l'étape de commutation b.

4. Procédé conforme à l'une quelconque des revendications précédentes,
selon lequel :
- avant le test l'intensité du courant de charge iL est comparée à une valeur de seuil de mode prédéfinie (SM),
- en cas de dépassement de cette valeur, le test est effectué selon un mode A et si non il est effectué selon un mode B.

5. Procédé conforme à la revendication précédente,
selon lequel
dans le mode B :
- l'instant de test tT est situé après l'étape de commutation b,
- lors du test :
• le courant i2 qui circule dans le premier chemin de transfert est détecté et comparé avec une valeur de seuil inférieure de courant circulaire prédéfinie (SKU),
• en cas de dépassement le résultat de test est considéré comme positif et sinon il est considéré comme négatif.

6. Procédé conforme à la revendication 5,
selon lequel :
- lors du test :
• le courant i3 qui circule dans le second chemin de transfert ou au travers de la première prise ou de la seconde prise est détecté et comparé avec une valeur de seuil supérieure prédéfinie du courant circulaire (SKO),
• en cas de passage au dessous de cette valeur le résultat du test est considéré comme positif et sinon il est considéré comme négatif.

7. Procédé conforme à l'une des revendications 5 et 6,
selon lequel,
l'instant de test tT est situé avec une durée de temporisation TV prédéfinie après le début (tb) de l'étape de commutation b.

8. Procédé conforme à l'une des revendications précédentes selon lequel :
- le test est effectué dans un intervalle de temps de test TT, qui s'étend du premier passage par zéro tN du courant de charge depuis le début (ta) de l'étape de commutation a à l'instant de test tT, et/ou
- le test est effectué après ou à partir du premier passage par zéro tN du courant de charge depuis le début (ta) de l'étape de commutation a et jusqu'à l'instant de test tT.

9. Procédé permettant de modifier le nombre d'enroulements actifs d'un enroulement de réglage dans une installation électrique (10) selon lequel :
- l'enroulement de réglage (12) est couplé à un réseau de courant alternatif ayant une période T prédéfinie, est conçu pour une intensité de courant nominale IN prédéfinie et comporte une première prise et une seconde prise (121, 122),
- on effectue une commutation selon un programme de commutation prédéfini entre un premier état de courant continu dans lequel un courant de charge (iL) circule de la première prise (121) vers une dérivation de charge (15) par un premier chemin principal et la seconde prise (122) est séparée de la dérivation de charge (15), et un second état de courant continu dans lequel le courant de charge circule de la seconde prise (122) vers la dérivation de charge (15) par un second chemin principal et la première prise (121) est séparée de la dérivation de charge (15), et
- le programme de commutation prescrit que :
• à partir du premier état de courant continu, dans une première étape de commutation a, la première prise (121) est ou reste reliée à la dérivation de charge (15) par un premier chemin de transfert et le premier chemin principal est séparé,
• après l'étape de commutation a, dans une étape de commutation b la second prise (122) est reliée à la dérivation de charge (15) par un second chemin de transfert de sorte que, en raison du gradin de tension entre les prises (121, 122) un courant continu iK circule dans les chemins de transfert,
• après l'étape de commutation b, dans une étape de commutation c le premier chemin de transfert est séparé,
• après l'étape de commutation c, dans une étape de commutation d la seconde prise (122) est reliée à la dérivation de charge (15) par le second chemin principal,
- à au moins un instant de test prédéfini tT entre l'étape de commutation c et l'étape de commutation d on vérifie si le premier chemin de transfert est séparé, et
- on détermine l'intensité iL du courant de charge,
- l'instant de test tT dépend de l'intensité iL du courant de charge.

10. Procédé conforme à la revendication précédente,
selon lequel :
- lors du test :
• le courant i2 qui circule dans le premier chemin de transfert est détecté et comparé avec une valeur de seuil de détection (SE) prédéfinie,
• en cas de passage au-dessous de cette valeur le résultat du test est considéré comme positif et sinon il est considéré comme négatif.

11. Procédé conforme à l'une des revendications 9 et 10,
selon lequel :
- l'instant de test tT est situé avec une durée de temporisation TV prédéfinie après le début (tc) de l'étape de commutation c, et/ou
- l'instant de test tT est situé avant l'étape de commutation d.

12. Procédé conforme à l'une des revendications 9 et 11,
selon lequel :
- le test est effectué dans un intervalle de test TT qui s'étend du premier passage par zéro tN du courant de charge depuis le début (tc) de l'étape de commutation c à l'instant de test tT, et/ou
- le test est effectué après ou à partir du premier passage par zéro tN du courant de charge depuis le début (tc) de l'étape de commutation c et jusqu'à l'instant de test Tt.

13. Procédé conforme à l'une des revendications précédentes,
selon lequel :
- le programme de commutation prescrit que :
• dans l'étape de commutation a le premier chemin principal est séparé en ouvrant un premier commutateur de séparation dans le premier chemin principal, et/ou
• dans l'étape de commutation c la première prise est séparée de la dérivation de charge en séparant le premier chemin de transfert est, en particulier en ouvrant un second commutateur de séparation dans le premier chemin de transfert, et/ou
• pendant/après l'étape de commutation d le second état de courant continu est atteint,
- le test du premier chemin principal s'effectue en testant l'ouverture du premier commutateur de séparation, et/ou
- le test du premier chemin de transfert s'effectue en testant l'ouverture du second commutateur de séparation, et/ou
- au moins l'un des commutateurs de séparation est réalisé sous la forme d'un commutateur à huile ou d'un tube de commutation à vide, et/ou
- au moins l'un des commutateurs de séparation est actionné à l'aide d'un entraînement direct.

14. Procédé conforme à l'une des revendications précédentes,
selon lequel :
- l'intensité iL du courant de charge est comparée avec une valeur de seuil supérieure prédéfinie (SO),
- en cas de dépassement la durée de temporisation tV est fixée à une valeur TV1 prédéfinie et en cas contraire à une valeur prédéfinie TV2>TV1.

15. Procédé conforme à l'une des revendications précédentes,
selon lequel :
- avant le test l'intensité du courant de charge iL est comparée avec une valeur de seuil inférieure prédéfinie (SU),
- en cas de dépassement le test est effectué et en cas contraire un plan d'urgence correspondant est mis en oeuvre.

16. Procédé conforme à l'une des revendications précédentes,
selon lequel :
- en cas de résultat positif du test, la commutation conforme au programme de commutation est poursuivie et en cas contraire un plan d'urgence correspondant est mis en oeuvre,
- selon le plan d'urgence :
• les étapes de commutation effectuées auparavant selon le programme de commutation sont effectuées dans l'ordre inverse, et/ou
• l'installation (10) est séparée du réseau de courant alternatif, et/ou
• on produit un signal d'alarme qui correspond au résultat négatif du test respectif.

17. Installation électrique (10) comprenant :
- un enroulement de réglage (12) qui est couplé à un réseau de courant alternatif ayant une période T prédéfinie, est conçu pour une intensité de courant nominale IN prédéfinie, et comporte une première prise et une seconde prise (121, 122),
- un commutateur à gradins de charge (11), qui est connecté aux prises (121,122) et comprend :
• une dérivation de charge (15),
• un premier chemin principal,
• un premier chemin de transfert,
• un second chemin de transfert,
• un second chemin principal,
• un dispositif commutateur de séparation (18) qui est conçu de manière à permettre de séparer et de relier chaque chemin principal et chaque chemin de transfert,
• un dispositif de commande (17) qui est couplé au dispositif commutateur de séparation (18),
**caractérisé en ce que**
- le commutateur à gradins de charge (11) est réalisé, pour modifier le nombre d'enroulements actifs de l'enroulement de réglage (12) de façon à permettre d'effectuer une commutation,
• selon un programme de commutation prédéfini, entre un premier état de courant continu dans lequel un courant de charge (iL) circule de la première prise (121) vers la dérivation de charge (15) par le premier chemin principal et la seconde prise (122) est séparée de la dérivation de charge (15), et un second état de courant continu dans lequel le courant de charge circule de la seconde prise (122) vers la dérivation de charge (15) par le second chemin principal et la première prise (121) est séparée de la dérivation de charge (15), et
- le programme de commutation prescrit que :
• à partir du premier état de courant continu, dans une première étape de commutation a la première prise (121) est ou reste reliée avec la dérivation de cas de charge (15) par le premier chemin de transfert, et le premier chemin principal est séparé,
• après l'étape de commutation a dans une étape de commutation b la seconde prise (122) est reliée avec la dérivation de charge (15) par le second chemin de transfert de sorte que, en raison du gradin de tension entre les prises (121, 122) un courant circulaire (iK) circule dans les chemins de transfert,
• après l'étape de commutation b, dans une étape de commutation c la première prise (121) est séparée de la dérivation de charge (15),
• après l'étape de commutation c dans une étape de commutation d la seconde prise (122) est reliée avec la dérivation de charge (15) par le second chemin principal,
- le dispositif de commande (17) est réalisé de façon,
• à pouvoir tester à au moins un instant de test prédéfini tT entre l'étape de commutation a et l'étape de commutation c si le premier chemin principal est séparé,
• à pouvoir déterminer l'intensité iL du courant de charge,
• à pouvoir déterminer l'instant de test tT en fonction de l'intensité du courant de charge iL.

18. Installation électrique (10) comprenant :
- un enroulement de réglage (12) qui est couplé à un réseau de courant alternatif ayant une période T prédéfinie, est conçu pour une intensité de courant nominale IN prédéfinie, et comporte une première prise et une seconde prise (121, 122),
- un commutateur à gradins de charge (11) qui est connecté aux prises (121, 122) et comprend :
• une dérivation de charge (15),
• un premier chemin principal,
• un premier chemin de transfert,
• un second chemin de transfert,
• un second chemin principal,
• un dispositif commutateur de séparation (18), qui est réalisé de façon à permettre de séparer et de relier chaque chemin principal et chaque chemin de transfert,
• un dispositif de commande (17) qui est couplé au dispositif commutateur de séparation (18),
**caractérisé en ce que**
- le commutateur à gradins de charge (11) est réalisé, pour modifier le nombre d'enroulements actifs de l'enroulement de réglage (12) de façon à permettre d'effectuer une commutation,
• entre un premier état de courant continu dans lequel un courant de charge (iL) circule de la première prise (121) vers la dérivation de charge (15) par le premier chemin principal et la seconde prise (122) est séparée de la dérivation de charge (15), et un second état de courant continu dans lequel le courant de charge (iL) circule de la second prise (122) vers la dérivation de charge (15) par le second circuit chemin principal et la première prise (121) est séparée de la dérivation de charge (15) conformément à un programme de commutation prédéfini,
- le programme de commutation prescrit que :
• à partir du premier état de courant continu, dans une étape de commutation a la première prise (121) est ou reste reliée à la dérivation de charge (15) par le premier chemin de transfert, et le premier chemin principal est séparé,
• après l'étape de commutation a, dans une étape de commutation b la seconde prise (122) est reliée à la dérivation de charge (15) par le second chemin de transfert de sorte que, en raison du gradin de tension entre la première prise et la seconde prise (121, 122) un courant circulaire (iK) circule dans les chemins de transfert,
• après l'étape de commutation b, dans une étape de commutation c le premier chemin de transfert est séparé,
• après l'étape de commutation c, dans une étape de commutation d la seconde prise (122) est reliée à la dérivation de charge (15) par le second chemin principal,
- le dispositif de commande (17) est réalisé de façon,
• à pouvoir tester à au moins un instant de test tT prédéfini entre l'étape de commutation c et l'étape de commutation d si le premier chemin de transfert est séparé,
• à pouvoir déterminer l'intensité de courant iL du courant de charge,
• à pouvoir déterminer l'instant de test tT en fonction de l'intensité iL du courant de charge.

19. Procédé ou installation (10) conforme à l'une des revendications précédentes,
selon lequel ou dans laquelle :
- l'installation (10) est une bobine de compensation réglable ou variable permettant de fournir une puissance réactive inductive dans le réseau de courant alternatif et/ou de compenser une puissance réactive capacitive provenant du réseau de courant alternatif, et l'enroulement de réglage (12) forme au moins une partie de la bobine de compensation, et/ou
- l'installation (10) comprend un transformateur de réglage ayant un côté primaire et un côté secondaire et l'enroulement de réglage (12) forme au moins une partie du côté primaire ou du côté secondaire.
